# EUROPEAN PATENT APPLICATION

(11) **EP 4 345 905 A1**
(43) Date of publication of application: **03.04.2024**
(21) Application number: 23192623.9
(22) Date of filing: 22.08.2023
(51) Int. Cl.: H01L 29/06, H01L 21/283, H01L 21/285, H01L 21/8238, H01L 23/528, H01L 29/08, H01L 29/417, H01L 29/423, H01L 21/336, H01L 29/775, B82Y 10/00

(54) **FIELD-EFFECT TRANSISTOR WITH UNIFORM SOURCE/DRAIN REGIONS ON SELF-ALIGNED DIRECT BACKSIDE CONTACT STRUCTURES OF BACKSIDE POWER DISTRIBUTION NETWORK (BSPDN)**

(30) Priority: 28.09.2022 US 202263410848 P; 15.02.2023 US 202318110296
(71) Applicant: Samsung Electronics Co., Ltd., Suwon-si, Gyeonggi-do 16677 (KR)
(72) Inventor: LEE, Jongjin, San Jose, CA 95134 (US); HONG, Wonhyuk, San Jose, CA 95134 (US); SEO, Kang-ill, San Jose, CA 95134 (US)
(74) Representative: Kuhnen & Wacker Patent- und Rechtsanwaltsbüro PartG mbB

(57) **Abstract**

Provided is field-effect transistor structure including: a channel structure; a 1^{st} source/drain region and a 2^{nd} source/drain region connected to each other through the channel structure; a 1^{st} contact plug, on a top surface of the 1^{st} source/drain region, connected to a 1^{st} voltage source or 1^{st} circuit element through a back-end-of-line (BEOL) structure; and a 2^{nd} contact plug, on a bottom surface of the 2^{nd} source/drain region, connected to the 1^{st} voltage source, through a backside power rail, or another circuit element, wherein the 1^{st} source/drain region and the 2^{nd} source/drain region have a substantially same height.

## Description

### BACKGROUND

### 1. Field

Apparatuses and methods consistent with example embodiments of the disclosure relate to a field-effect transistor (FET) having uniform-sized source/drain regions on self-aligned direct backside contact structures of backside power distribution network (BSPDN).

### 2. Description of Related Art

Growing demand for an integrated circuit having a high device density and performance has introduced a field-effect transistor (FET) such as fin field-effect transistor (FinFET) and a nanosheet transistor. The FinFET has one or more horizontally arranged vertical fin structures as a channel structure of which at least three surfaces are surrounded by a gate structure, and the nanosheet transistor is characterized by one or more nanosheet channel layers vertically stacked on a substrate as a channel structure, and a gate structure surrounding all four surfaces of each of the nanosheet channel layers. The nanosheet transistor is referred to as gate-all-around (GAA) transistor, multi-bridge channel field-effect transistor (MBCFET)

Further, a backside power distribution network (BSPDN) formed at a back side of the field-effect transistor has been introduced to address a routing complexity at a back-end-of-line (BEOL), that is, a front side of the field-effect transistor, and prevent excessive IR drop at the front side in the field-effect transistor. The BSPDN includes a backside power rail through which a positive or negative voltage may be supplied to a source/drain region of the field-effect transistor.

The backside power rail may be connected to a top surface of the source/drain region using a front via backside power rail (FVBP) structure as a contact plug. Alternatively, the backside power rail may also be directly connected to a bottom surface of the source/drain region using a direct backside contact (DBC) structure as the contact plug. However, the formation of the DBC structure in the back side of the field-effect transistor with the BSPDN may affect formation of other elements of the field-effect transistor including source/drain regions. Thus, there is demand of an improved semiconductor device or cell structure including a field-effect transistor having both a backside contact plug and a front side contact plug and a method of manufacturing the same.

Information disclosed in this Background section has already been known to the inventors before achieving the embodiments of the present application or is technical information acquired in the process of achieving the embodiments described herein. Therefore, it may contain information that does not form prior art that is already known to the public.

### SUMMARY

Various example embodiments provide a semiconductor cell including at least one field-effect transistor in which a front side contact plug and a backside contact plug are formed on respective source/drain regions having the same or substantially same height or size.

The embodiments also provide a method of manufacturing the semiconductor cell including at least one field-effect transistor in which a front side contact plug and a backside contact plug are formed on respective source/drain regions having the same or substantially same height or size.

According to embodiments, there is provided a field-effect transistor structure which may include: a channel structure; a 1^{st} source/drain region and a 2^{nd} source/drain region connected to each other through the channel structure; a 1^{st} contact plug, on a top surface of the 1^{st} source/drain region, connected to a 1^{st} voltage source or 1^{st} circuit element through a back-end-of-line (BEOL) structure; and a 2^{nd} contact plug, on a bottom surface of the 2^{nd} source/drain region, connected to the 1^{st} voltage source, through a backside power rail, or another circuit element, wherein the 1^{st} source/drain region and the 2^{nd} source/drain region have a substantially same height.

According to embodiments, there is provided a field-effect transistor structure which may include: a channel structure; a 1^{st} source/drain region and a 2^{nd} source/drain region connected to each other through the channel structure; a 1^{st} contact plug, on a top surface of the 1^{st} source/drain region, connected to a 1^{st} voltage source or 1^{st} circuit element through a back-end-of-line (BEOL) structure; and a 2^{nd} contact plug, on a bottom surface of the 2^{nd} source/drain region, connected to the 1^{st} voltage source, through a backside power rail, or another circuit element, wherein the 1^{st} source/drain region and the 2^{nd} source/drain region have a substantially same size, and top surfaces of the 1^{st} source/drain region and the 2^{nd} source/drain region are substantially at a same level, in a cross-section view in a channel-width direction or a channel-length direction.

According to embodiments, there is provided a method of manufacturing a field-effect transistor structure. The method may include: forming a channel structure on a substrate; forming 1^{st} and 2^{nd} recesses on the substrate such that the channel structure is positioned vertically on a portion of the substrate between the 1^{st} and 2^{nd} recesses; forming 1^{st} and 2^{nd} placeholder structures in the 1^{st} and 2^{nd} recesses, respectively; forming 1^{st} and 2^{nd} source/drain regions on the 1^{st} and 2^{nd} placeholder structures, respectively; removing the 1^{st} and 2^{nd} placeholder structures from the 1^{st} and 2^{nd} recesses; and forming a backside contact plug in the 2^{nd} recess from which the 2^{nd} placeholder structure is removed

### BRIEF DESCRIPTION OF DRAWINGS

Example embodiments of the disclosure will be more clearly understood from the following detailed description taken in conjunction with the accompanying drawings in which:
FIG. 1A-1D illustrate a semiconductor cell after dummy gate structures are formed to surround a plurality of channel structures on a substrate, according to an embodiment;
FIG. 2A-2D illustrate a semiconductor cell after thin protective liners are formed in side surfaces of a plurality of trenches formed between the dummy gate structures, according to an embodiment;
FIGS. 3A-3D illustrate a semiconductor cell after a 1^{st} photoresist and masking structure is formed on the semiconductor cell obtained in the previous step, according to an embodiment;
FIGS. 4A-4D illustrate a semiconductor cell after the previously-formed trenches between the dummy gate structures are exposed again based on the 1^{st} photoresist and masking structure, and a base diffusion isolation (BDI) layer exposed through the trenches is removed, according to an embodiment;
FIGS. 5A-5D illustrate a semiconductor cell after portions of the substrate exposed by the removed BDI layer are recessed to form a plurality of recesses in the substrate, according to an embodiment;
FIGS. 6A-6D illustrate a semiconductor cell after a portion of the 1^{st} photoresist and masking structure used to form the recesses in the substrate is removed and these recesses are modified to have a 1^{st} predetermined shape having a positive slope, according to an embodiment;
FIGS. 7A-7D illustrate a semiconductor cell after a plurality of placeholder structures including dummy placeholder structures are filled in the recesses formed in the substrate, according to an embodiment;
FIGS. 8A-8D illustrate a semiconductor cell after a blocking layer is formed on a top surface of each of the placeholder structures in the substrate, according to an embodiment;
FIGS. 9A-9D illustrate a semiconductor cell after the thin protective liners formed in the trenches are removed, according to an embodiment;
FIGS. 10A-10D illustrate a semiconductor cell after source/drain regions for two nanosheet transistors are formed, according to an embodiment;
FIGS. 11A-11D illustrate a semiconductor cell after a 1^{st} interlayer dielectric (ILD) structure is formed thereon and the gate hard mask structure is removed to expose the dummy gate structure formed therebelow, according to an embodiment;
FIGS. 12A-12D illustrate a semiconductor cell after the dummy gate structures and sacrificial layers included in the channel structures are removed, according to an embodiment;
FIGS. 13A-13D illustrate a semiconductor cell after a plurality of gate structures replace the dummy gate structures and the sacrificial layers in the channel structures, according to an embodiment;
FIGS. 14A-14D illustrate a semiconductor cell after a 2^{nd} photoresist and masking structure is formed on the semiconductor cell obtained in the previous step, according to an embodiment;
FIGS. 15A-15D illustrate a semiconductor cell after the 2^{nd} photoresist and masking structure are opened at a position corresponding to a gate-cut structure to be formed in a subsequent step, according to an embodiment;
FIGS. 16A-16D illustrate a semiconductor cell after a gate-cut trench is formed in the semiconductor cell obtained in the previous step, according to an embodiment;
FIGS. 17A-17D illustrate a semiconductor cell after the gate-cut trench is filled in with a dielectric material, according to an embodiment;
FIGS. 18A-18D illustrate a semiconductor cell after a 2^{nd} ILD structure is formed thereon, according to an embodiment;
FIGS. 19A-19D illustrate a semiconductor cell after a plurality of MOL contact plugs are formed on the source/drain regions and the gate structures, according to an embodiment;
FIGS. 20A-20D illustrate a semiconductor cell after a 3^{rd} ILD structure and a plurality of via structures therein are formed on the semiconductor cell obtained in the previous step, according to an embodiment;
FIGS. 21A-21D illustrate a semiconductor cell after a 4^{th} ILD structure and a plurality of 1^{st} metal lines therein are formed, according to an embodiment;
FIGS. 22A-22D illustrate a semiconductor cell after a plurality of back-end-of-line (BEOL) layers, a bonding layer and a carrier wafer are formed on the 1^{st} metal lines, according to an embodiment;
FIGS. 23A-23D illustrate a semiconductor cell after the substrate is etched to expose an etch stop layer formed at a predetermined level from a bottom of the substrate, according to an embodiment;
FIGS. 24A-24D illustrate a semiconductor cell after the etch stop layer is removed, according to an embodiment;
FIGS. 25A-25D illustrate a semiconductor cell after the substrate is removed, according to an embodiment;
FIGS. 26A-26D illustrate a semiconductor cell after a 5^{th} ILD structure is formed on a back side of the semiconductor cell to enclose the placeholder structures, according to an embodiment;
FIGS. 27A-27D illustrate a semiconductor cell after a backside masking structure is formed at a back side of the semiconductor cell to expose the dummy placeholder structures to be removed in a subsequent step, according to an embodiment;
FIGS. 28A-28D illustrate a semiconductor cell after the dummy placeholder structures are removed, according to an embodiment;
FIGS. 29A-29D illustrate a semiconductor cell after spaces left from the removal of the dummy placeholder structures are filled in with a 6^{th} ILD structure, and a back side of the semiconductor cell is planaraized to form the remaining placeholder structures in a 2^{nd} predetermined shape having a positive slope, according to an embodiment;
FIGS. 30A-30D illustrate a semiconductor cell after the remaining placeholder structures are removed, according to an embodiment;
FIGS. 31A-31D illustrate a semiconductor cell after the blocking layers are removed, according to an embodiment;
FIGS. 32A-32D illustrate a semiconductor cell after backside contact plugs are formed in spaces left from the removal of the remaining placeholder structures and the blocking layers thereon, according to an embodiment;
FIGS. 33A-33D illustrate a semiconductor cell after a 7^{th} ILD structure and a backside power rail therein, according to an embodiment;
FIGS. 34A-34D illustrate a semiconductor cell in which no blocking layers remain between source/drain regions and the 6^{th} ILD structures after the semiconductor cell is finished up, according to an embodiment;
FIGS. 35A-35D illustrate a semiconductor cell in which blocking layers remain between source/drain regions and the 6^{th} ILD structures and between source/drain regions and backside contact plugs when the semiconductor cell is finished up, according to an embodiment;
FIGS. 36A-36D illustrate a semiconductor cell including two field-effect transistors each of which has two source/drain regions having different heights or sizes, according to an embodiment;
FIG. 37 is a flowchart illustrating a method of manufacturing a semiconductor device including a field-effect transistor of which source/drain regions are connected to a front side contact plug and a backside contact plug, respectively, according to embodiments; and
FIG. 38 is a schematic block diagram illustrating an electronic device including a field-effect transistor having both a front side contact plug and a backside contact plug as shown in FIGS. 33A-33D, FIGS. 34A-34D, FIGS. 35A-35D or FIGS. 36A-36D, according to an embodiment.

### DETAILED DESCRIPTION OF EMBODIMENTS

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, nanosheet sacrificial layers, sacrificial isolation layers and channel isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, elements described as "below" or "beneath" other elements would then be oriented "above" the other elements. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor and materials forming the same may or may not be described in detail herein. For example, a certain isolation layer or structure of a semiconductor device and materials forming the same may be omitted herein when this layer or structure is not related to the novel features of the embodiments.

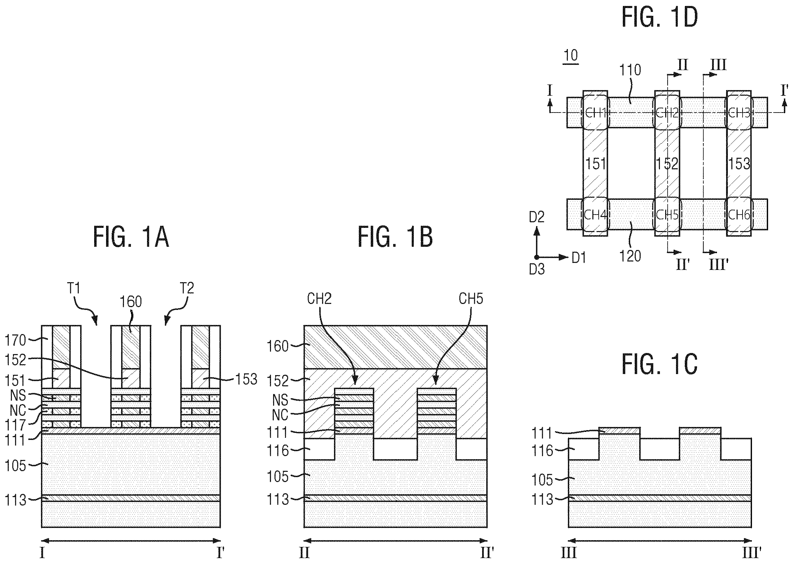

Herebelow, various embodiments of the disclosure will be described in reference to FIGS. 1A-1D to FIG. 35, in which FIGS. 1A-1D through FIGS. 33A-33D illustrate a process of manufacturing a semiconductor cell including nanosheet transistors in which a source/drain region with a backside contact plug and a source/drain region with a front side contact plug have a same or substantially same height or size, according to embodiments.

FIGS. 1D to 34D are top plan views of a semiconductor cell 10, and FIGS. 1A-1C to 34A-34C are cross-sectional views of the semiconductor cell 10 taken along lines I-I', II-II' and III-III' indicated in FIGS. 1D to 34D, respectively. It is understood here that FIGS. 1D to 34D are provided only to help understanding of positions of selected structural elements of the nanosheet transistors including fin (channel) structures and dummy gate or gate structures in the semiconductor cell 10, for brevity purposes, and thus, not all of the structural elements illustrated in FIGS. 1A-1C to 34A-34C are shown in FIGS. 1D to 34D.

FIG. 1A-1D illustrate a semiconductor cell after dummy gate structures are formed to surround a plurality of channel structures on a substrate.

Referring to FIGS. 1A-1D, 1^{st} and 2^{nd} fin structures 110 and 120 may be formed on a substrate 105, and extended in a D1 direction which is a channel length direction. The 1^{st} and 2^{nd} fin structures 110 and 120 may be spaced apart from each other in a D2 direction, which is a channel width direction, by a shallow trench isolation (STI) structures 116. The D1 and D2 directions may intersect each other or may be perpendicular to each other.

Further, two trenches T1 and T2 may be formed on the substrate 105 to divide a dummy gate structure formed on the 1^{st} and 2^{nd} fin structures 110 and 120 into 1^{st} to 3^{rd} dummy gate structures 151-153 respectively extended in the D2 direction. The two trenches T1 and T2 along with the STI structures 116 may also divide the 1^{st} and 2^{nd} fin structures 110 and 120 into 1^{st} to 6^{th} channel structures CH1-CH6. Thus, the 1^{st} dummy gate structure 151 may surround the 1^{st} and 4^{th} channel structures CH1 and CH4, the 2^{nd} dummy gate structure 152 may surround the 2^{nd} and 5^{th} channel structures CH2 and CH5, and the 3^{rd} dummy gate structure 153 may surround the 3^{rd} and 6^{th} channel structures CH3 and CH6.

The dummy gate structure is referred to as such as they are to be replaced by a replacement metal gate (RMG) structure in a later step of manufacturing the semiconductor cell 10. The dummy gate structure may be formed of polycrystalline silicon (p-Si), for example.

Each of the channel structures CH1-CH6 may include a plurality of nanosheet layers NC on a plurality of sacrificial layers NS, respectively. The nanosheet layers NC, formed of, for example, silicon (Si), are referred to as channel layers as they are to function as current paths between source/drain regions when the semiconductor cell 10 is completed to include a plurality of nanosheet transistors formed of the channel structures CH1-CH6. The sacrificial layers NS, formed of, for example, silicon germanium (SiGe), are referred to as such as they, along with the dummy gate structures 151-153, will be replaced by the RMG structures after source/drain regions for two nanosheet transistors are formed in the semiconductor cell 10 in a later step.

A base diffusion isolation or bottom dielectric isolation (BDI) layer 111 may be formed on the substrate 105 to isolate the substrate 105 from gate structures and source/drain regions to be formed in a later step so that current leakage from these structures may be prevented. The BDI layer 111 may include silicon nitride, silicon carbon nitride (SiCN) or silicon boron carbon nitride (SiBCN), not being limited thereto.

A gate hard mask structure 160 which was used to form the dummy gate structures 151-153 may remain on each of the dummy gate structures 151-153 at this step of manufacturing the semiconductor cell 10.

An inner spacer 117 may be formed at both sides of each of the sacrificial layers NS in the D1 direction to isolate the sacrificial layer NS from source/drain regions to be formed in a later step. A gate spacer 170 may be formed at both sides of each of the dummy gate structures 151-153 to isolate the RMG structures which will replace the dummy gate structures 151-153 in a later step from other structural elements in the semiconductor cell 10. The gate spacer 170 may also be extended in a D3 direction to be formed at both sides of the gate hard mask structure 160 on each of the dummy gate structure 151-153. The D3 direction may intersect or may be perpendicular to the D1 and D2 directions. Further, an etch stop layer 113 may be formed in the substrate 105 at a predetermined level from a bottom surface of the substrate 105.

FIGS. 1A-1D show that the semiconductor cell 10 includes two fin structures divided into six channel structures, each of which has three channel layers, and three dummy gate structures surrounding the six channel structures. However, these numbers of the structural elements are only an example. Thus, more or less than those numbers of the structural elements may form the semiconductor cell 10, according to embodiments.

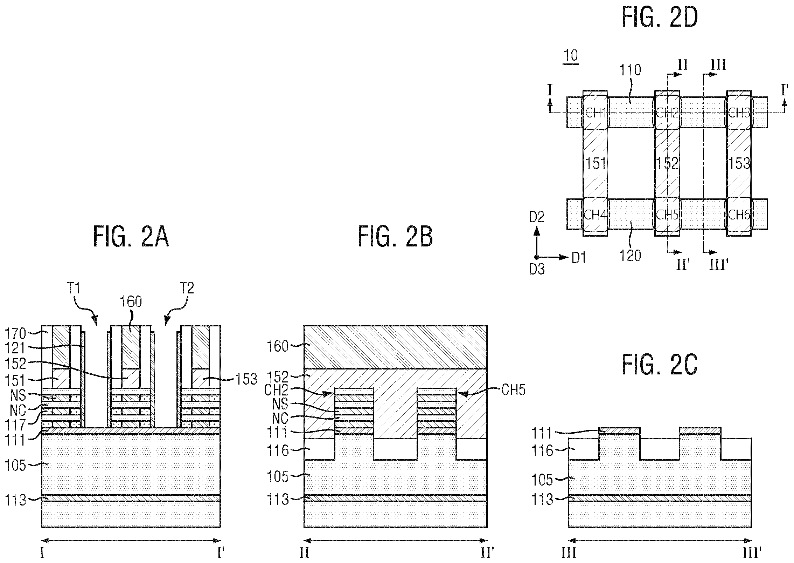

FIG. 2A-2D illustrate a semiconductor cell after thin protective liners are formed on side surfaces of a plurality of trenches formed between the dummy gate structures.

Referring to FIG. 2A, thin protective liners 121 may be formed on side surfaces of the trenches T1 and T2. A side surface of each of the trenches T1 and T2 may be formed of side surfaces of the inner spacer 117, the nanosheet layer NC and the gate spacer 170 which may be coplanar in the D3 direction. The thin protective liners 121 may be used to protect at least the inner spacer 117, the nanosheet layer NC and the gate spacer 170 in a later step of forming a plurality of placeholder structures in the substrate 105 below the two trenches T1 and T2 after removing the BDI layer 111 on the substrate 105. Thus, the thin protective liners 121 may be required to be formed of a material having etch selectivity against the BDI layer 111 and the substrate 105. The material forming the thin protective liners 121 may include at least one of silicon nitride, silicon oxynitride (SiON), silicon carbide (SiC), silicon carbon nitride (SiCN), not being limited thereto, different from the material included in the BDI layer 111.

At least one of the placeholder structures mentioned above will be formed in the substrate 105 to reserve a space for forming a backside contact plug of a BSPDN therein as will be described later. The backside contact plug is to be connected to a bottom surface of a corresponding source/drain region which will also be described later. The backside contact plug may refer to the direct backside contact (DBC) structure mentioned in the Background section of the instant specification. The formation of the thin protective liners 121 may be performed through, for example, atomic layer deposition (ALD).

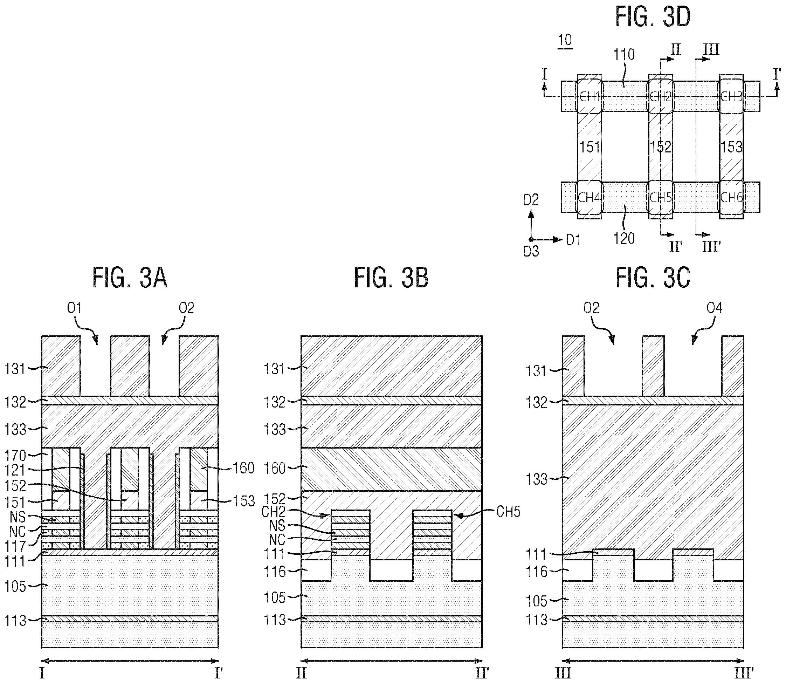

FIGS. 3A-3D illustrate a semiconductor cell after a 1^{st} photoresist and masking structure is formed on the semiconductor cell obtained in the previous step.

Referring to FIGS. 3A-3C, a 1^{st} photolithography and masking operation may be performed on the semiconductor cell 10. For example, the 1^{st} photolithography and masking operation may include a tri-layer patterning operation forming a plurality of photoresist patterns 131 on a silicon-containing anti-reflective coating (SiARC) layer 132 and an organic planarization layer (OPL) 133 which may be filled in the trenches T1 and T2, and cover the fin structures 110 and 120.

The photoresist patterns 131 may be formed on the SiARC layer 132 with 1^{st} to 4^{th} openings O1-O4 to expose the SiARC layer 132 above the trenches T1 and T2 through which placeholder structures are to be formed in a later step. For brevity purposes, the 3^{rd} opening O3 is not shown in FIGS. 3A-3C.

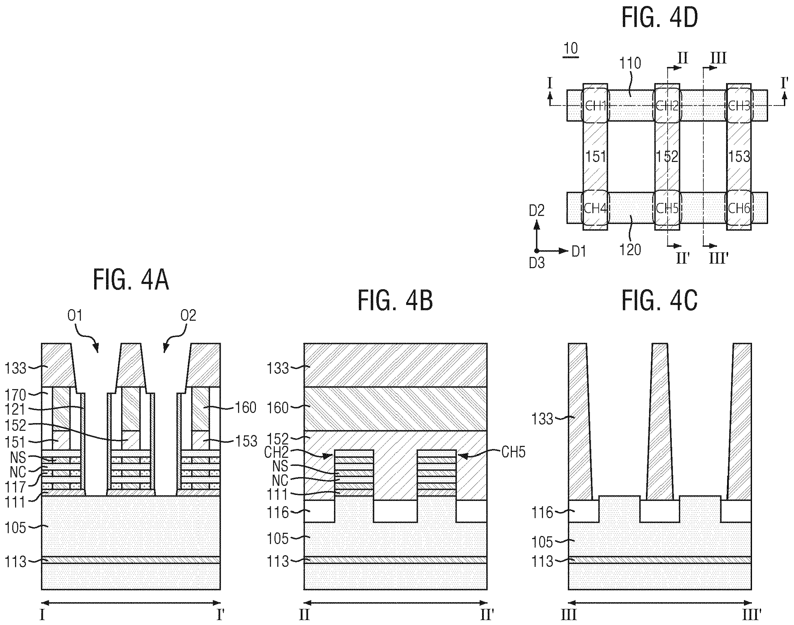

FIGS. 4A-4D illustrate a semiconductor cell after the previously-formed trenches between the dummy gate structures are exposed again based on the 1^{st} photoresist and masking structure, and a base diffusion isolation (BDI) layer exposed through the trenches is removed to expose the substrate.

Referring to FIGS. 4A-4C, portions of the SiARC layer 132 and the OPL 133 below the 1^{st} to 4^{th} openings O1-O4 may be removed through, for example, dry etching and/or wet etching, based on the photoresist patterns 131. At this time, the BDI layer 111 exposed through the trenches T1 and T2, from which the OPL 133 is removed, may also be removed.

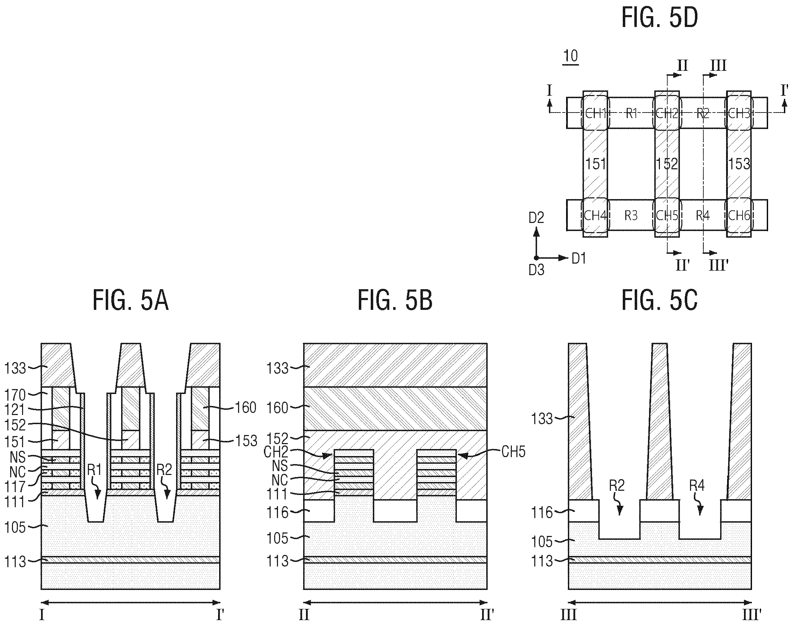

FIGS. 5A-5D illustrate a semiconductor cell after portions of the substrate exposed by the removed BDI laver are recessed to form a plurality of recesses in the substrate.

Referring to FIGS. 5A-5C, 1^{st} to 4^{th} recesses R1-R4 may be formed in the substrate 105 to accommodate formation of the placeholder structures in a later step. These recesses R1-R4 may be formed in the substrate 105 below a level of the BDI layer 111, which is now removed. The formation of the recesses R1-R4 may be performed through, for example, dry etching, not being limited thereto.

According to an embodiment, the recesses R1-R4 may have a depth from a top surface of the substrate 105 to a level above the predetermined level where the etch stop layer 113 is formed.

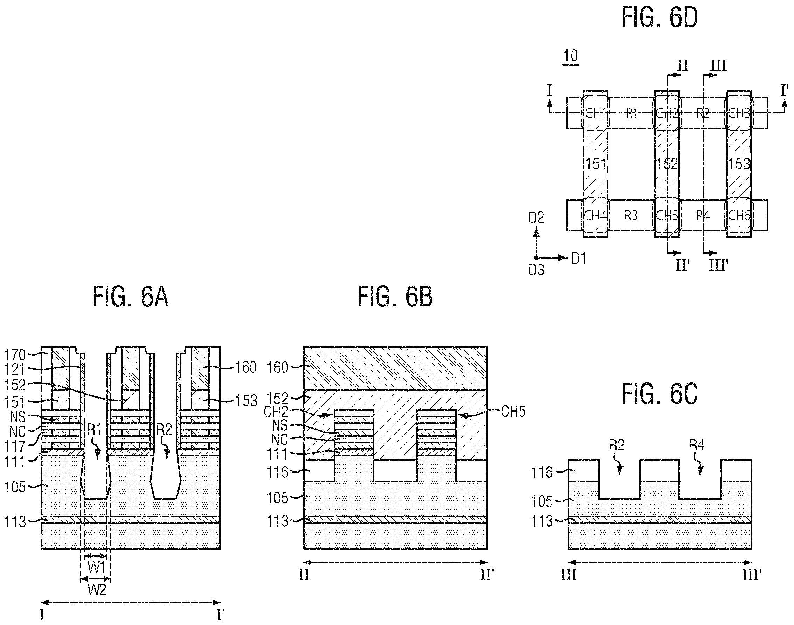

FIGS. 6A-6D illustrate a semiconductor cell after a portion of the 1^{st} photoresist and masking structure used to form the recesses in the substrate is removed and these recesses are modified to have a 1^{st} predetermined shape having a positive slope.

Referring to FIGS. 6A and 6C, the OPL 133 used to form the 1^{st} to 4^{th} recesses R1-R4 may be removed through, for example, an ashing operation to expose the gate hard mask structure 160. Further, additional etching may be performed on the 1^{st} to 4^{th} recesses R1-R4 such that these recesses can have a 1^{st} predetermined shape with at least a positive slope portion. For example, the recesses R1-R4 after the additional etching may take a form of a hexagon (or trapezoid) in a cross-section view in the channel-length direction (FIG. 6A) while they may take a form of a rectangle in a cross-section view in the channel-width direction (FIG. 6C). As another example, the recesses R1-R4 after the additional etching may take a form of the 1^{st} predetermined shape in at least one of a cross-section view in the channel-width direction and a cross-section view in the channel-length direction. The additional etching performed in this step may include sigma etching, according to an embodiment.

The hexagonal (or trapezoidal) shape has a positive slope, and thus, an upper width W1 of each of the recesses R1-R4 is smaller than a lower width W2 thereof. By forming the recesses R1-R4 in this shape, formation of backside contact plugs therein in the substrate 105 will be facilitated as will be described later.

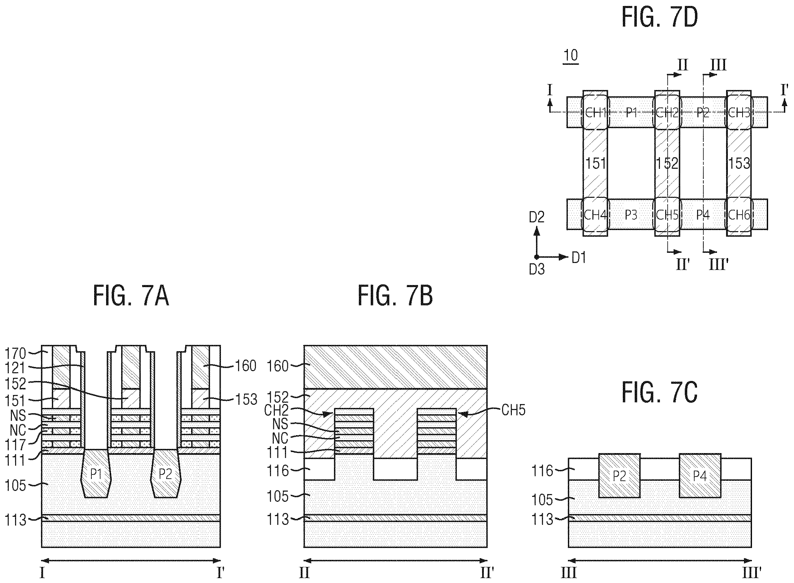

FIGS. 7A-7D illustrate a semiconductor cell after a plurality of placeholder structures including dummy placeholder structures are filled in the recesses formed in the substrate.

Referring to FIGS. 7A and 7C, 1^{st} to 4^{th} placeholder structures P1-P4 may be formed in the 1^{st} to 4^{th} recesses R1 to R4, respectively, through, for example, chemical vapor deposition (CVD), plasma enhanced CVD (PECVD), physical vapor deposition (PVD), atomic layer deposition (ALD), or a combination thereof, not being limited thereto.

As will be described later, the 2^{nd} and 3^{rd} placeholder structures P2 and P3 may be formed to provide respective spaces for formation of backside contact plugs connected to bottom surfaces of corresponding source/drain regions in the semiconductor cell 10 in a later step. In contrast, the 1^{st} and 4^{th} placeholder structures P1 and P4 may be used to contribute to formation of source/drain regions having a same or substantially same height or size as the corresponding source/drain regions, and then, may be replaced by an interlayer dielectric (ILD) structure in a later step. Thus, the 1^{st} and 4^{th} placeholder structures P1 and P4 may be referred to as dummy or sacrificial placeholder structures herein.

The placeholder structures P1-P4 may be formed of silicon germanium (SiGe), for example, not being limited thereto.

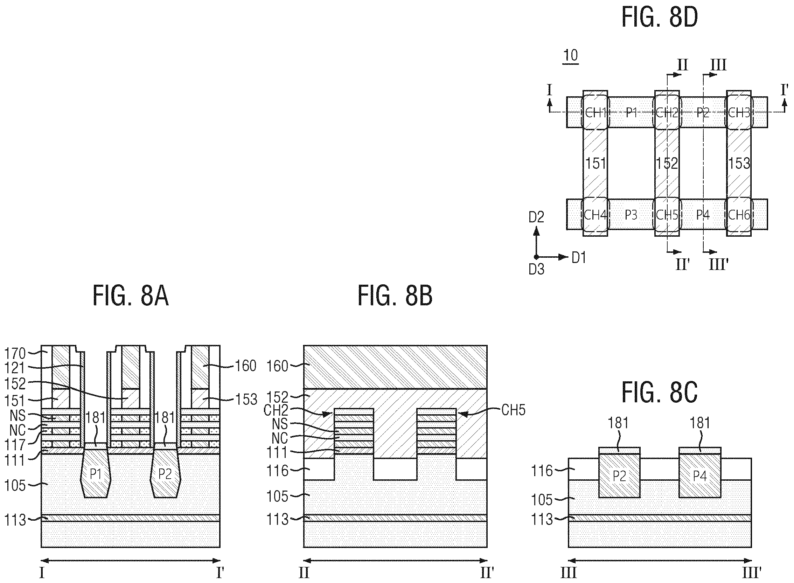

FIGS. 8A-8D illustrate a semiconductor cell after a blocking layer is formed on a top surface of each of the placeholder structures in the substrate.

Referring to FIGS. 8A and 8C, a blocking layer 181 may be formed on a top surface of each of the 1^{st} to 4^{th} placeholder structures P1-P4 in the substrate 105. The blocking layer 181 may be formed through, for example, epitaxially growing silicon (Si) from the placeholder structures P1-P4 or atomic layer deposition (ALD) of a dielectric material such as silicon oxide or silicon nitride, not being limited thereto.

As will be described later, the blocking layer 181 may be used at least to prevent loss of epitaxial structure forming a source/drain region formed thereabove when a placeholder structure therebelow is removed in a later step. Further, the blocking layer 181 may be used to protect the placeholder structures P1-P4 when the thin protective liner 121 is removed in a next step.

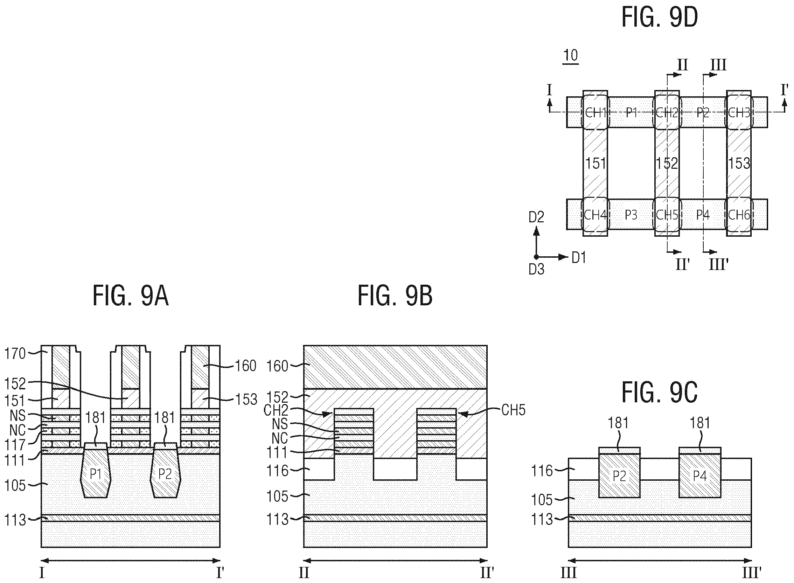

FIGS. 9A-9D illustrate a semiconductor cell after the thin protective liners formed in the trenches are removed.

Referring to FIG. 9A, the thin protective liner 121 formed at the side surfaces of the trenches T1 and T2 may be removed though, for example, atomic layer etching (ALE). By removing the thin protective liners 121, side surfaces of the nanosheet layers NC, the inner spacer 117 and the gate spacer 170 may be exposed again through the trenches T1 and T2.

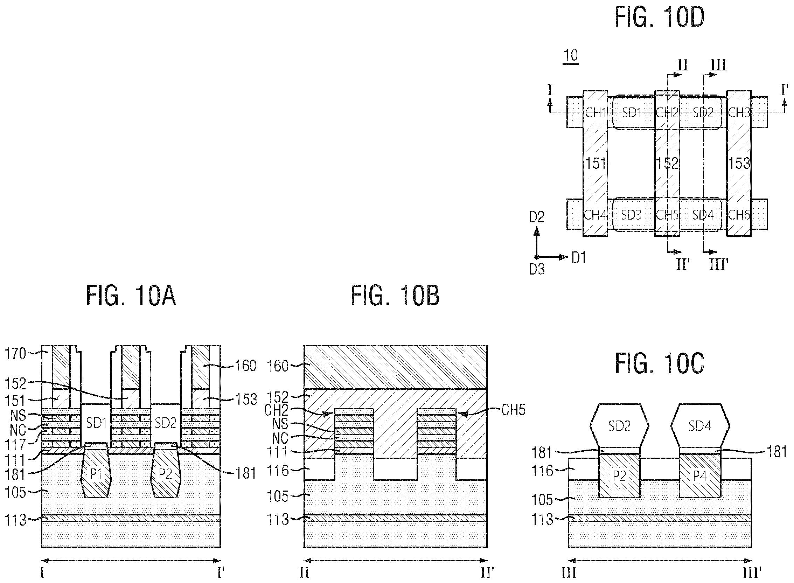

FIGS. 10A-10D illustrate a semiconductor cell after source/drain regions for two nanosheet transistors are formed.

Referring to FIGS. 10A and 10C, 1^{st} to 4^{th} source/drain regions SD1-SD4 may be epitaxially grown based on the 1^{st} to 6^{th} channel structures CH1-CH6 and the blocking layer 181 with respective placeholder structures therebelow.

According to an embodiment, each of the 1^{st} to 4^{th} source/drain regions SD1-SD4 may be a p-type source/drain region including silicon germanium (SiGe), which may be the same as the material forming the placeholder structures P1-P4. This p-type source/drain region may be doped with p-type impurities such as boron (B), gallium (Ga), etc.

Since each of the 1^{st} to 4^{th} source/drain regions SD1-SD4 is formed based on the same structural elements, that is, two channel structures at both sides of the source/drain region and the blocking layer 181 with the corresponding placeholder structure therebelow, the 1^{st} to 4^{th} source/drain regions SD1-SD4 may have a same or substantially same height or size, and further, top surfaces of the 1^{st} to 4^{th} source/drain regions SD1-SD4 may be at a substantially same level. According to an embodiment, the 1^{st} to 4^{th} source/drain regions SD1-SD4 may have a same or substantially same height or size in at least one of a cross-section view in the channel-width direction and a cross-section view in the channel-length direction.

Thus, a 1^{st} nanosheet transistor TR1 including the 1^{st} and 2^{nd} source/drain regions SD1 and SD2 and a 2^{nd} nanosheet transistor TR2 including the 3^{rd} and 4^{th} source/drain regions SD3 and SD4 to be completed in the semiconductor cell 10 a later step may have a stable and consistent device performance.

As described earlier in reference to FIGS. 7A-7D and will be described further, the 2^{nd} and 3^{rd} source/drain regions SD2 and SD3 are to be connected to backside contact plugs that will replace the placeholder structures P2 and P3 while the 1^{st} and 4^{th} source/drain regions SD1 and SD4 may be connected to front side contact plugs in a later step. Thus, when the semiconductor cell 10 is formed by a related-art method, only the placeholder structures P2 and P3 may be formed to provide a space for the backside contact plugs for the 2^{nd} and 3^{rd} source/drain regions SD2 and SD3. In this case, the size or height of the 2^{nd} and 3^{rd} source/drain regions SD2 and SD3 formed on the placeholder structures P2 and P3 with the blocking layer 181 may differ from that of the 1^{st} and 4^{th} source/drain regions SD1 and SD4 formed on the substrate 105 without the placeholder structures P1 and P4 with the blocking layer 181 thereon. In the present embodiments, however, the placeholder structures P1 and P4 with the blocking layer 181 may also be formed in the substrate 105 so that the 1^{st} and 4^{th} source/drain regions SD1 and SD4 may be formed based on the same conditions as the 2^{nd} and 3^{rd} source/drain regions, that is, based on same placeholder structures with a blocking layer thereon. Thus, the embodiments may enable formation of same- or substantially same-sized source/drain regions for the 1^{st} and 2^{nd} nanosheet transistors TR1 and TR2 having both a backside contact plug and a front side contact plug for their source/drain regions.

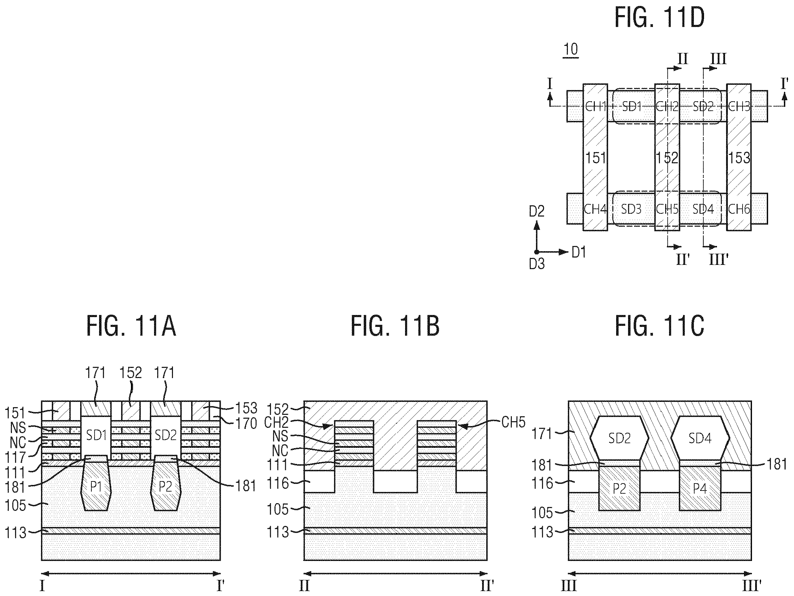

FIGS. 11A-11D illustrate a semiconductor cell after a 1^{st} interlayer dielectric (ILD) structure is formed thereon and the gate hard mask structure is removed to expose the dummy gate structure formed therebelow.

Referring to FIGS. 11A-11C, a 1^{st} ILD structure 171 may be formed to isolate the 1^{st} to 4^{th} source/drain regions SD1-SD4 from each other and from other structural elements in the semiconductor cell 10. The formation of the 1^{st} ILD structure 171 may be performed through, for example, CVD, PECVD, PVD, ALD or a combinations thereof, followed by an ashing or planarization operation such as chemical-mechanical polishing (CMP) to remove the gate hard mask structure 160, thereby exposing the dummy gate structures 151-153 upward.

A material forming the 1^{st} ILD structure 171 may be a low-k material such as silicon oxide, silicon nitride, silicon oxynitride, etc., not being limited thereto. Here, it is understood that additional ILD structures 172-177 to be formed in the semiconductor cell 10 in later steps may also be formed of the same low-k material forming the 1^{st} ILD structure 171 or a different low-k material.

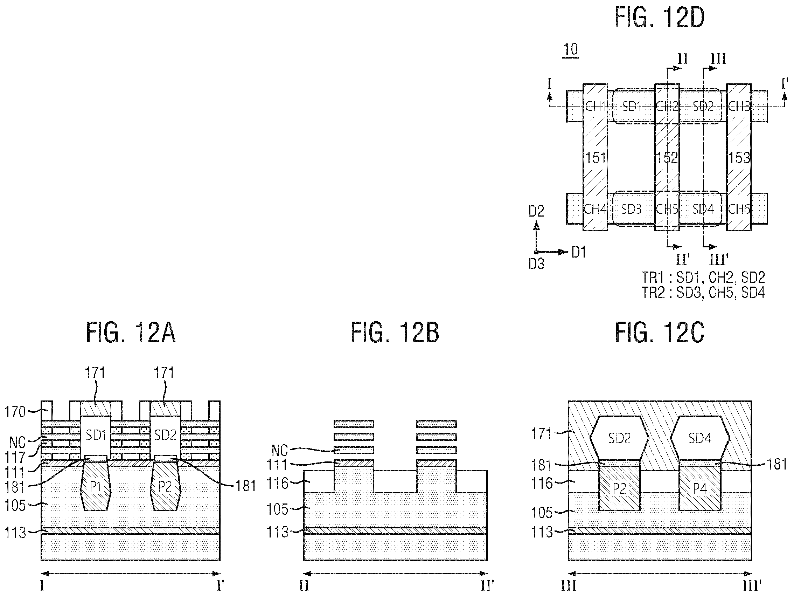

FIGS. 12A-12D illustrate a semiconductor cell after the dummy gate structures and sacrificial layers included in the channel structures are removed.

Referring to FIGS. 12A-12C, the dummy gate structures 151-153 may be removed along with the sacrificial layers NS included in the 1^{st} to 6^{th} channel structures CH1 to CH6. The removal operation in this step may include isotropic and/or anisotropic reactive ion etching (RIE), wet etching and/or a chemical oxide removal (COR) process, not being limited thereto. Thus, in the semiconductor cell 10, the nanosheet layers NC may be released from the sacrificial layers NS to form a plurality of channel layers for the nanosheet transistors TR1 and TR2. By this channel release operation, the nanosheet layers NC may be exposed through an open space where gate structures are to be formed in a subsequent step.

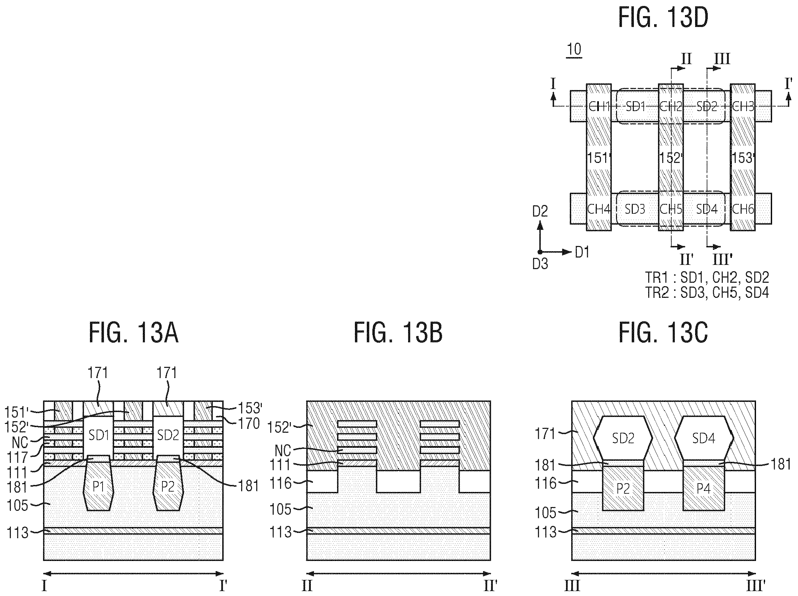

FIGS. 13A-13D illustrate a semiconductor cell after a plurality of gate structures replace the dummy gate structures and the sacrificial layers in the channel structures.

Referring to FIGS. 13A and 13B, 1^{st} to 3^{rd} replacement metal gate (RMG) structures 151'-153' are formed on the spaces where the dummy gate structures 151-153 and the sacrificial layers NS are removed in the previous step. By this replacement operation, the 1^{st} to 3^{rd} RMG structures 151'-153' may surround the 1^{st} to 6^{th} channel structures CH1 to CH6, respectively, to control current flows through these channel structures. The RMG structures 151'-153' are referred to as such because these structures have replaced the dummy gate structures 151-153 in the semiconductor cell 10.

Each of the RMG structures 151'-153' may include a gate dielectric layer, a work-function layer, and a gate electrode. The gate dielectric layer may be formed of an oxide material and a high-k material, and the work-function layer may be formed of titanium (Ti), tantalum (Ta) or their compound. The gate electrode may be formed of copper (Cu), aluminum (Al), tungsten (W), molybdenum (Mo), ruthenium (Ru), cobalt (Co) or their compound, not being limited thereto.

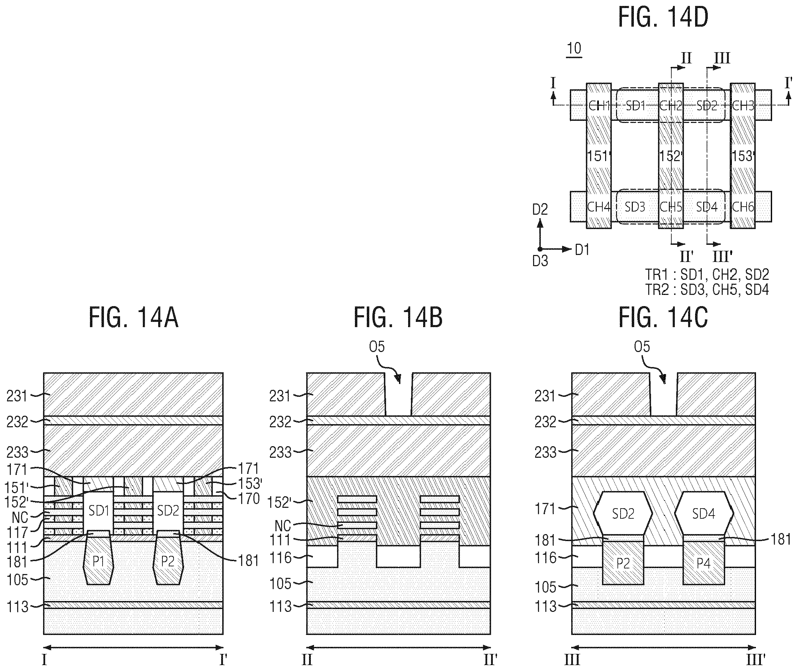

FIGS. 14A-14D illustrate a semiconductor cell after a 2^{nd} photoresist and masking structure is formed on the semiconductor cell obtained in the previous step.

Referring to FIGS. 14A-14C, a 2^{nd} photolithography and masking operation may be performed on the semiconductor cell 10. For example, the 2^{nd} photolithography and masking operation may also include a tri-layer patterning operation forming a plurality of photoresist patterns 231 on a silicon-containing anti-reflective coating (SiARC) layer 232 and an organic planarization layer (OPL) 233.

Here, the photoresist patterns 231 may be formed on the SiARC layer 232 with a 5^{th} opening O5 that exposes the SiARC layer 232 above a position between the 1^{st} fin structure 110 and the 2^{nd} fin structures 120 at which a gate-cut structure is to be formed in a later step.

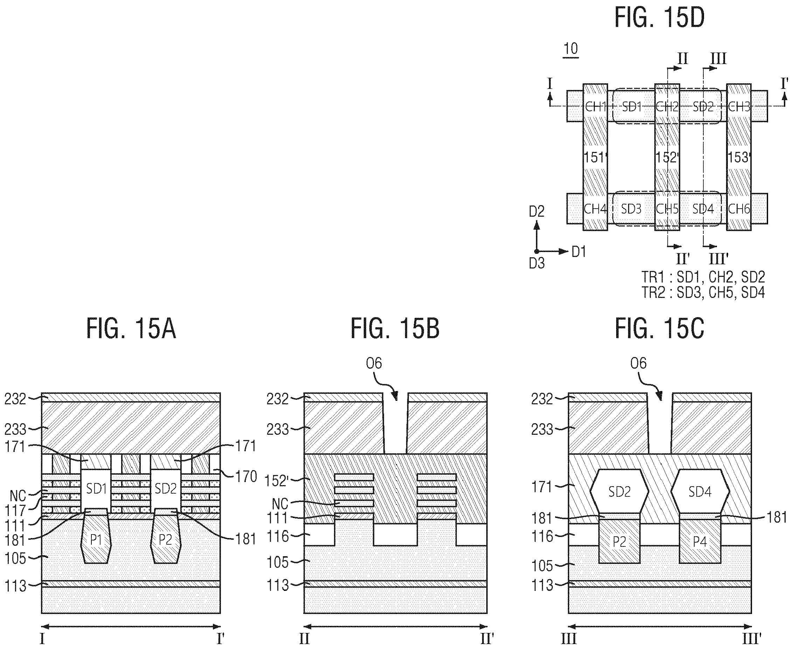

FIGS. 15A-15D illustrate a semiconductor cell after the 2^{nd} photoresist and masking structure are opened at a position corresponding to a gate-cut structure to be formed in a subsequent step.

Referring to FIGS. 15A-15C, the SiARC layer 232 and the OPL 233 are opened to form a 6^{th} opening O6 at a position where the gate-cut structure is to be formed based on the photoresist patterns 231 with the 5^{th} opening O5. The formation of the 6^{th} opening O6 in this step may be performed through, for example, dry etching based on the photoresist patterns 231 with the 5^{th} opening O5.

After formation of the SiARC layer 232 and the OPL 233 with the 6^{th} opening O6, the photoresist patterns 231 may be removed through, for example, an ashing operation.

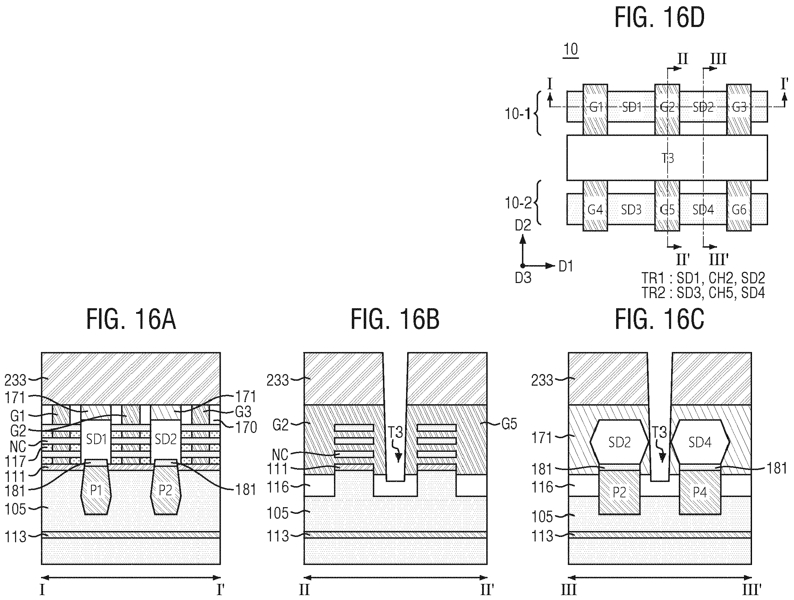

FIGS. 16A-16D illustrate a semiconductor cell after a gate-cut trench is formed in the semiconductor cell obtained in the previous step.

Referring to FIGS. 16A-16C, a 3^{rd} trench T3, which is a gate-cut trench, may be formed to divide the semiconductor cell 10 into a 1^{st} semiconductor cell 10-1 and a 2^{nd} semiconductor cell 10-2. The gate cut trench T3 may also divide the 1^{st} to 3^{rd} RMG structures 151'-153' into 1^{st} to 3^{rd} gate structures G1-G3 in the 1^{st} semiconductor cell 10-1 and 4^{th} to 6^{th} gate structures G4-G6 in the 2^{nd} semiconductor cell 10-2.

The formation of the 3^{rd} trench T3 may be performed through, for example, dry etching based on the SiARC layer 232 and the OPL 233 with the 6^{th} opening O6 in the semiconductor cell 10 of the previous step. By the gate-cut operation in this step, the 1^{st} to 6^{th} gate structures G1-G6 may take a form of surrounding the 1^{st} to 6^{th} channel structures CH1-CH6, respectively, in the semiconductor cell 10. The trench T3 may extend down to the STI structure 116.

After the formation of the 3^{rd} trench T3, the SiARC layer 232 may be stripped away, leaving the OPL 233 on the semiconductor cell 10.

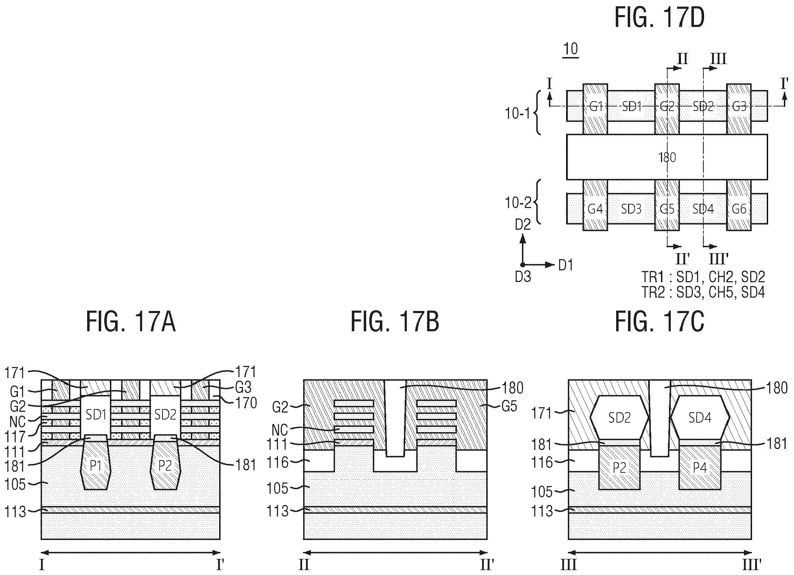

FIGS. 17A-17D illustrate a semiconductor cell after the gate-cut trench is filled in with a dielectric material.

Referring to FIGS. 17A-17C, the 3^{rd} trench T3 may be filled in with a gate-cut structure 180 formed of a dielectric material such as silicon oxide or silicon nitride through, for example, CVD, PVD, PECVD, ALD and a combination thereof, not being limited thereto.

After the formation of the gate-cut structure 180 in the 3^{rd} trench T3, the OPL 233 may be removed through, for example, an ashing or dry etching operation.

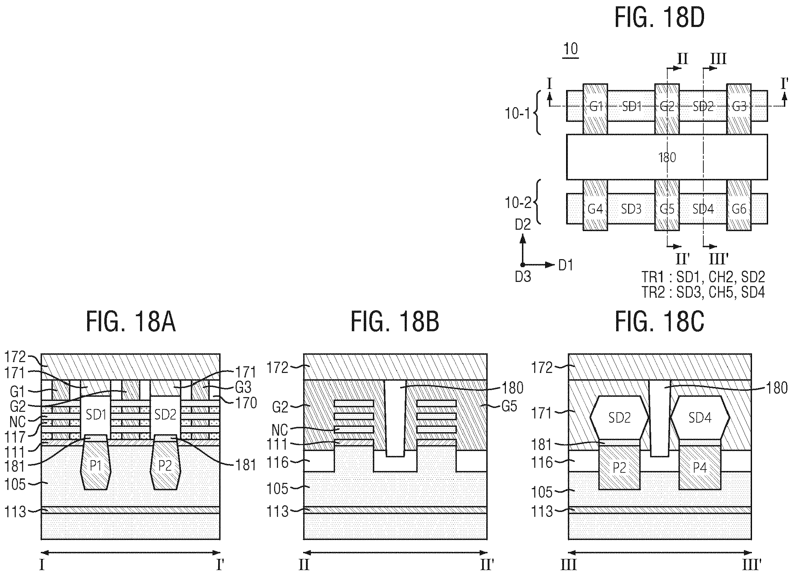

FIGS. 18A-18D illustrate a semiconductor cell after a 2^{nd} ILD structure is formed thereon.

Referring to 18A-18C, a 2^{nd} ILD structure 172, which may be referred to as a middle-of-line (MOL) ILD structure, may be formed on the 1^{st} and 2^{nd} semiconductor cells 10-1 and 10-2 through, for example, CVD, PVD, PECVD, ALD and a combination thereof, not being limited thereto.

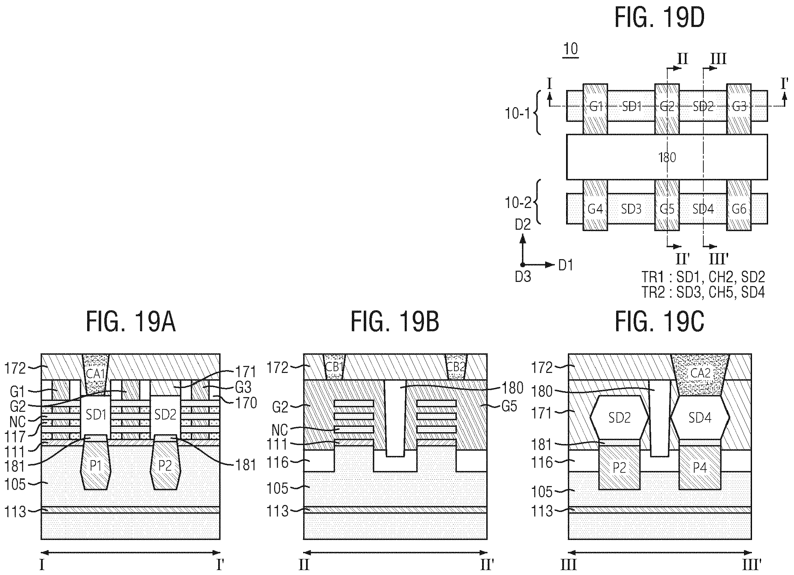

FIGS. 19A-19D illustrate a semiconductor cell after a plurality of MOL contact plugs are formed on the source/drain regions and the gate structures.

Referring to FIGS. 19A-19C, the 1^{st} and 2^{nd} ILD structures 171 and 172 may be patterned through, for example, a photolithography and masking operation, to provide a plurality of openings that expose top surfaces of the 1^{st} and 4^{th} source/drain regions SD1-SD4 and the 2^{nd} and 4^{th} gate structures, respectively. Further, these openings may be filled in with 1^{st} to 4^{th} MOL contact plugs CA1, CB1, CB2 and CA2 through, for example, CVD, PVD, PECVD, ALD, or a combination thereof such that the 1^{st} to 4^{th} MOL contact plugs CA1, CB1, CB2 and CA2 may be connected to the top surfaces of the 1^{st} source/drain region SD1, the 2^{nd} and 5^{th} gate structures G2 and G5, and the 4^{th} source/drain region SD4, respectively.

The 1^{st} to 4^{th} MOL contact plugs CA1, CB1, CB2 and CA2 may be formed of one or more metals or metal compounds such as copper (Cu), titanium (Ti), tantalum (Ta), aluminum (Al), tungsten (W), cobalt (Co), molybdenum (Mo), ruthenium (Ru), etc.

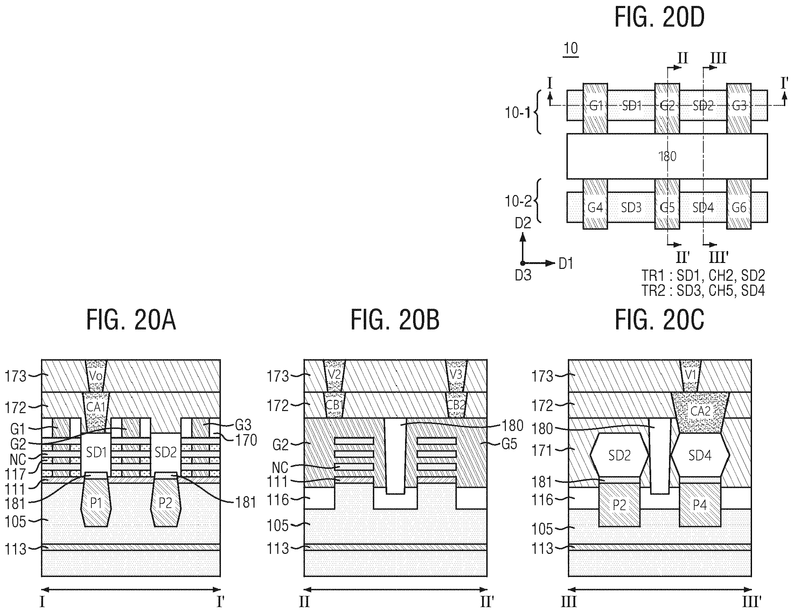

FIGS. 20A-20D illustrate a semiconductor cell after a 3^{rd} ILD structure and a plurality of via structures therein are formed on the semiconductor cell obtained in the previous step.

Referring to FIGS. 20A-20C, a 3^{rd} ILD structure 173 may be formed on the 2^{nd} ILD structure 172 with the 1^{st} to 4^{th} MOL contact plugs CA1, CA2, CB1 and CB2 therein, and the 3^{rd} ILD structure 173 may be patterned to provide a plurality of openings that expose top surfaces of the 1^{st} to 4^{th} MOL contact plugs CA1, CB1, CB2 and CA2. The openings may be filled in with 1^{st} to 4^{th} via structures V0-V3 to be connected to the top surfaces of the 1^{st} to 4^{th} MOL contact plugs CA1, CB1, CB2 and CA2, respectively.

The 3^{rd} ILD structure 173 and the 1^{st} to 4^{th} via structures V0-V3 may be formed through a similar process used to form the 2^{nd} ILD structure 172 and the 1^{st} to 4^{th} MOL contact plugs CA1, CB1, CB2 and CA2 in the previous step. The 1^{st} to 4^{th} via structures V0-V3 may include a material the same as or similar to that of the 1^{st} to 4^{th} MOL contact plugs CA1, CB1, CB2 and CA2.

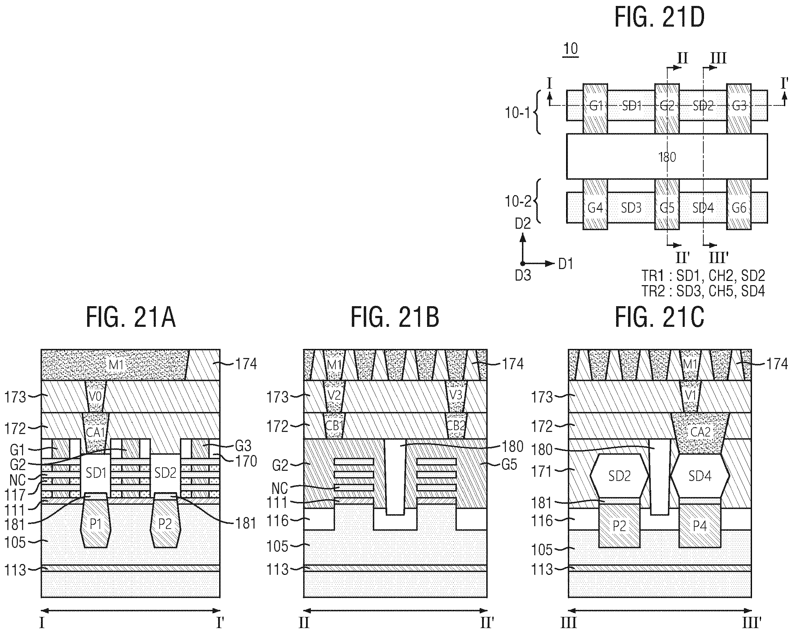

FIGS. 21A-21D illustrate a semiconductor cell after a 4^{th} ILD structure and a plurality of 1^{st} metal lines therein are formed.

Referring to FIGS. 21A-21C, a 4^{th} ILD structure 174 may be formed on the 3^{rd} ILD structure 173 with the 1^{st} to 4^{th} via structures V0-V3 therein, and the 4^{th} ILD structure 174 may be patterned to provide a plurality of trenches and/or openings that expose top surfaces of the 1^{st} to 4^{th} via structures V0-V3. These trenches and/or openings may be filled in with a plurality of 1^{st} metal lines M1 to be connected to the top surfaces of the 1^{st} to 4^{th} via structures V0-V3, respectively.

The 4^{th} ILD structure 174 and the 1^{st} metal lines M1 may be formed through a similar process used to form the 3^{rd} ILD structure 173 and the 1^{st} to 4^{th} via structures V0-V3 in the previous step. The 1^{st} metal lines M1 may include a material the same as or similar to that of the 1^{st} to 4^{th} MOL contact plugs CA1, CB1, CB2 and CA2.

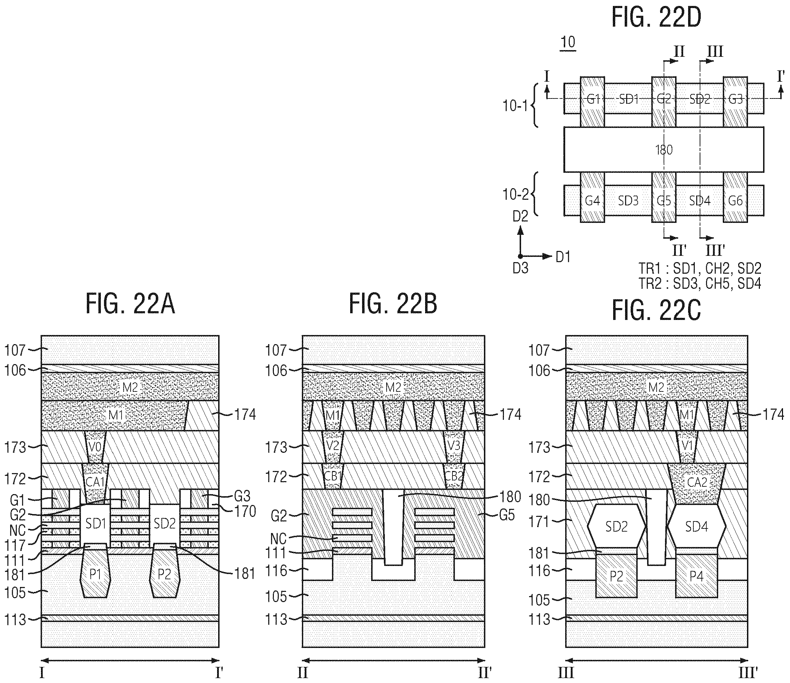

FIGS. 22A-22D illustrate a semiconductor cell after a plurality of back-end-of-line (BEOL) layers, a bonding layer and a carrier wafer are formed on the 1^{st} metal lines.

Referring to FIGS. 22A-22C, a plurality of BEOL layers M2 may be formed on the 1^{st} metal lines M1 through a similar process used to form the 4^{th} ILD structure 173 and the 1^{st} metal lines M1 in the previous step. Thus, the BEOL layers M2 may connect the 1^{st} and 4^{th} source/drain regions to a voltage source or another circuit element inside or outside the semiconductor cell 10 through the 1^{st} and 4^{th} MOL contact plugs CA1 and CA2. The BEOL layers M2 may include one or more metal lines and via structures formed at one or more levels.

Simultaneously or subsequently, a carrier wafer 107 may be formed on the BEOL layers M2 with a bonding layer 106 therebetween through, for example, CVD, PVD, PECVD, ALD, or their combination, not being limited thereto. The carrier wafer 107 may include a material such as silicon forming the substrate 105.

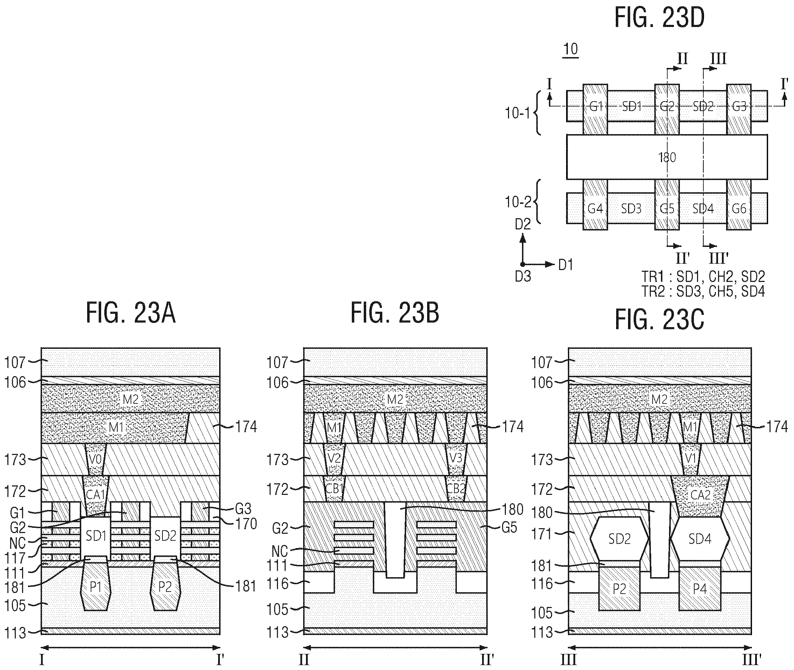

FIGS. 23A-23D illustrate a semiconductor cell after the substrate is etched to expose an etch stop layer formed at a predetermined level from a bottom surface of the substrate.

Referring to FIGS. 23A-23D, a portion of the substrate 105 may be removed through, for example, dry etching and/or planarization to expose the etch stop layer 113. It is understood here that, absent the etch stop layer 113 at the predetermined level from the bottom surface of the substrate 105, the dry etching and/or planarization may be excessive to remove even the placeholder structures P1-P4 in the substrate 105. Thus, the etch stop layer 113, which may be formed of aluminum nitride (AlN) or silicon carbon nitride (SiCN), not being limited thereto, may prevent such excessive etching and/or planarization of the substrate 105.

Although not shown in the drawings, the substrate removal operation in this step may be performed after the semiconductor cell 10 obtained in the previous step is flipped upside down based on the carrier wafer 107 to facilitate the instant removal operation and subsequent etching/deposition operations.

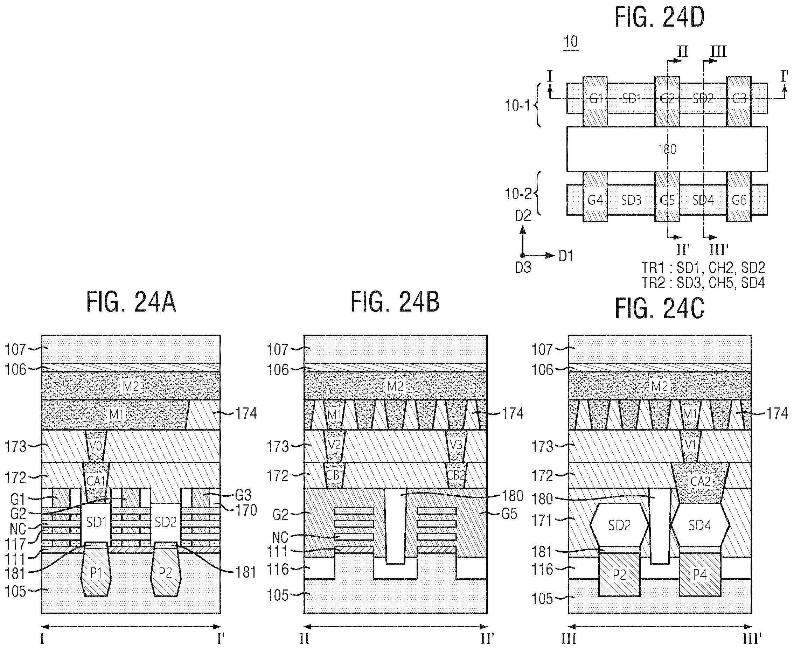

FIGS. 24A-24D illustrate a semiconductor cell after the etch stop layer is removed.

Referring to FIGS. 24A-24D, the etch stop layer 113 may be removed through, for example, wet etching to expose the substrate 105 above the etch stop layer.

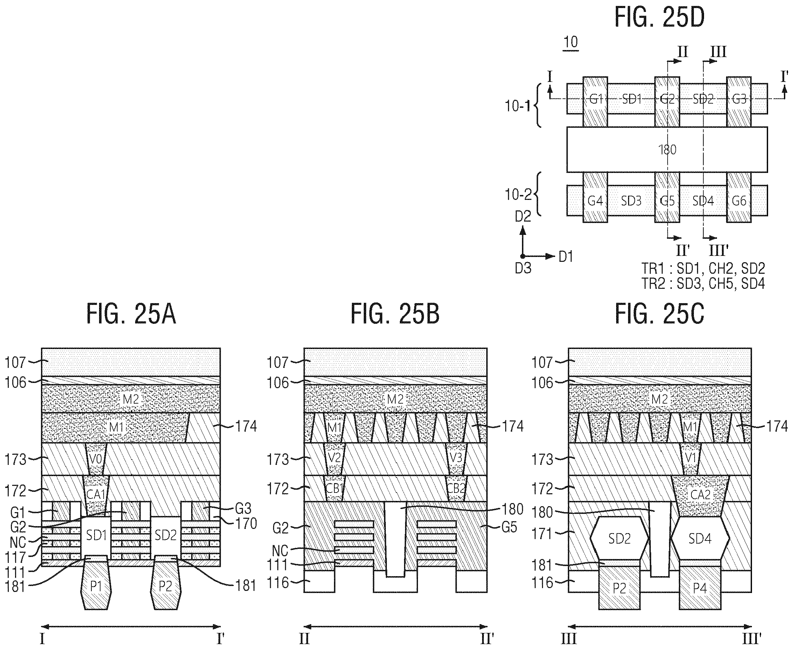

FIGS. 25A-25D illustrate a semiconductor cell after the substrate is removed.

Referring to FIGS. 25A-25C, the substrate 105 may be removed, for example, in its entirety, from a back side of the semiconductor cell 10 leaving the placeholder structures P1-P4 with the STI structure 116. As the substrate 105 is removed, the placeholder structures P1-P4, the STI structure 116, and the BDI layer 111 may be exposed to an outside. The substrate removal operation in this step may be performed through, for example, wet etching, not being limited thereto.

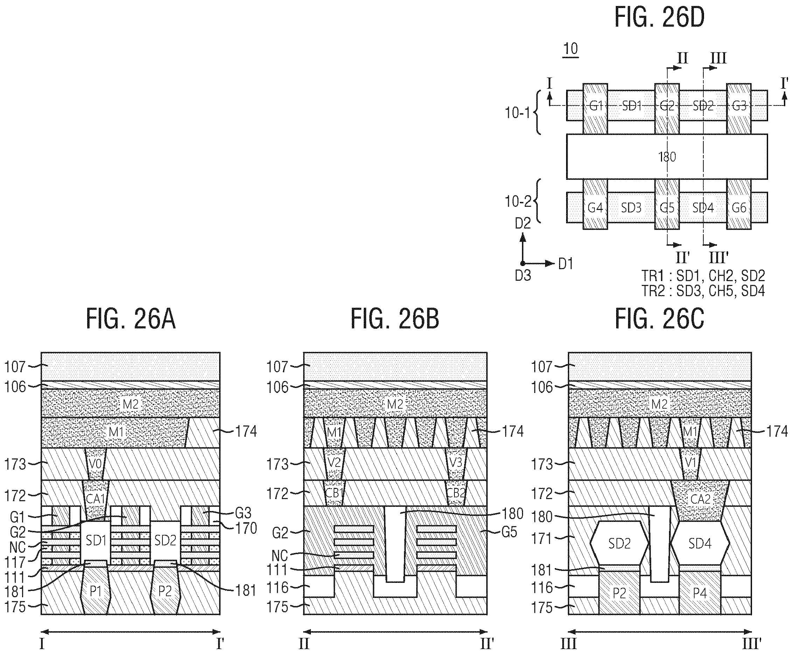

FIGS. 26A-26D illustrate a semiconductor cell after a 5^{th} ILD structure is formed on a back side of the semiconductor cell to enclose the placeholder structures.

Referring to FIGS. 26A-26C, a 5^{th} ILD structure 175 may be formed at a back side of the semiconductor cell 10 obtained in the previous step to fill a space generated by the removal of the substrate 105, and enclose the placeholder structures P1-P4 therein. Further, the 5^{th} ILD structure 175 may be planarized to expose bottom surfaces of the placeholder structures P1-P4, that is, top surfaces thereof in a state of the semiconductor cell 10 being flipped upside down. The 5^{th} ILD structure 175 may be referred to as a backside ILD structure.

The planarization operation in this step may be performed by chemical-mechanical polishing (CMP), for example.

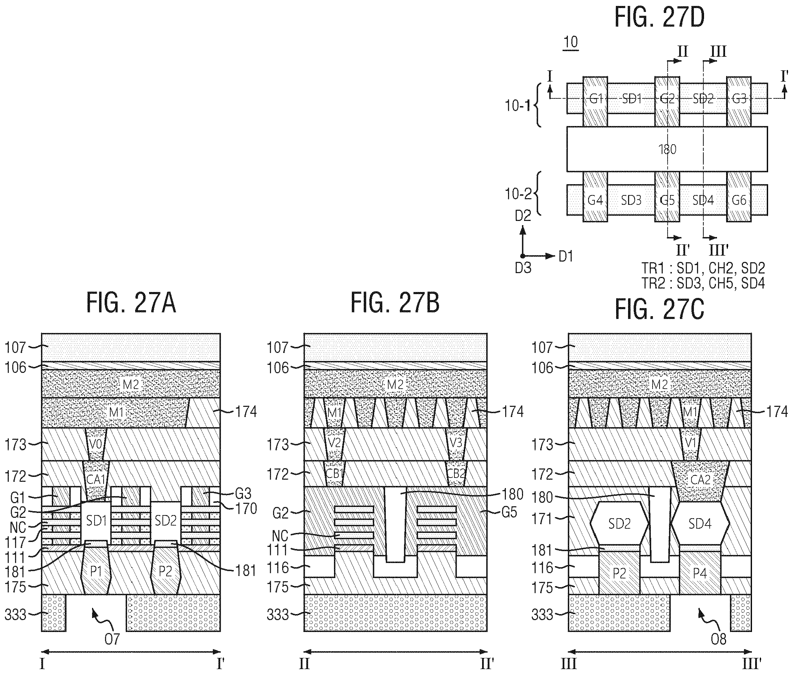

FIGS. 27A-27D illustrate a semiconductor cell after a backside masking structure is formed at a back side of the semiconductor cell to expose the dummy placeholder structures to be removed in a subsequent step.

Referring to FIGS. 27A-27C, a backside masking structure 333 may be formed on the back side of the semiconductor cell 10 to expose at least the bottom surfaces of the 1^{st} and 4^{th} placeholder structures P1 and P4 which are formed below the 1^{st} and 4^{th} source/drain regions connected to the 1^{st} and 4^{th} MOL contact plugs CA1 and CA2. The backside masking structure 333 may expose the 1^{st} and 4^{th} placeholder structures P1 and P4 through 7^{th} and 8^{th} openings O7 and O8, respectively.

As described earlier, each of the 1^{st} and 4^{th} MOL contact plugs CA1 and CA2 are connected to not a backside power rail (BPR) but a BEOL structure at a front side of the semiconductor cell 10.

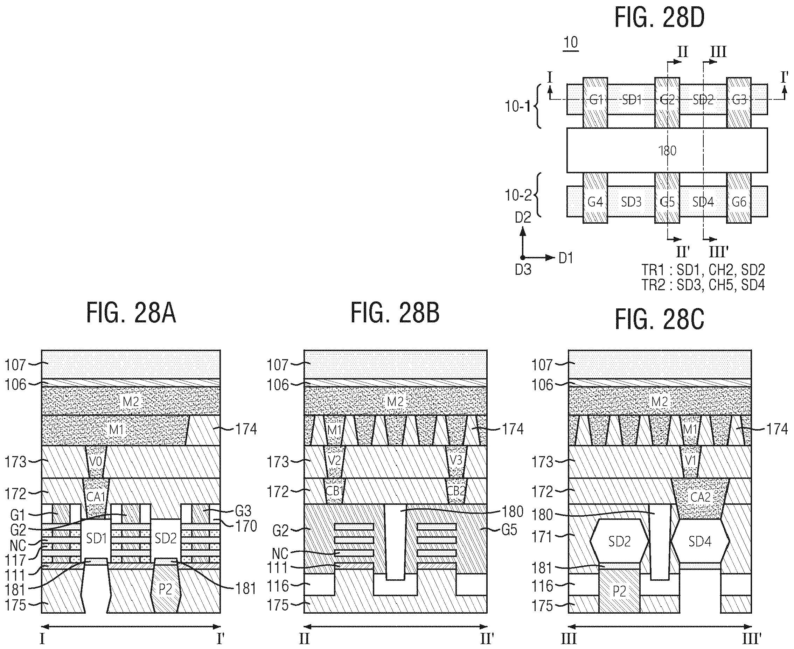

FIGS. 28A-28D illustrate a semiconductor cell after the dummy placeholder structures and the masking structure are removed.

Referring to FIGS. 28A-28C, the 1^{st} and 4^{th} placeholder structures P1 and P4 may be extracted through, for example, wet etching against the 5^{th} ILD structure 175 and the backside masking patterns 333.

At this time, the blocking layers 181 on the 1^{st} and 4^{th} placeholder structures P1 and P4 and below the 1^{st} and 4^{th} source/drain regions SD1 and SD4 may also be removed unlike in FIGS. 28A-28D to prevent or decrease unnecessary interference by these blocking layers 181 to other structural elements including the 1^{st} and 4^{th} source/drain regions SD1 and SD4 or an ILD structure to be formed therebelow, according to an embodiment. However, even in this embodiment, the blocking layers 181 on the 2^{nd} and 3^{rd} placeholder structures P2 and P3 and below the 2^{nd} and 3^{rd} source/drain regions SD2 and SD3 may not be removed to remain thereon at least to protect the 2^{nd} and 3^{rd} source/drain regions SD2 and SD3 formed thereon in a later step of replacing the 2^{nd} and 3^{rd} placeholder structures P2 and P3 with the backside contact plugs.

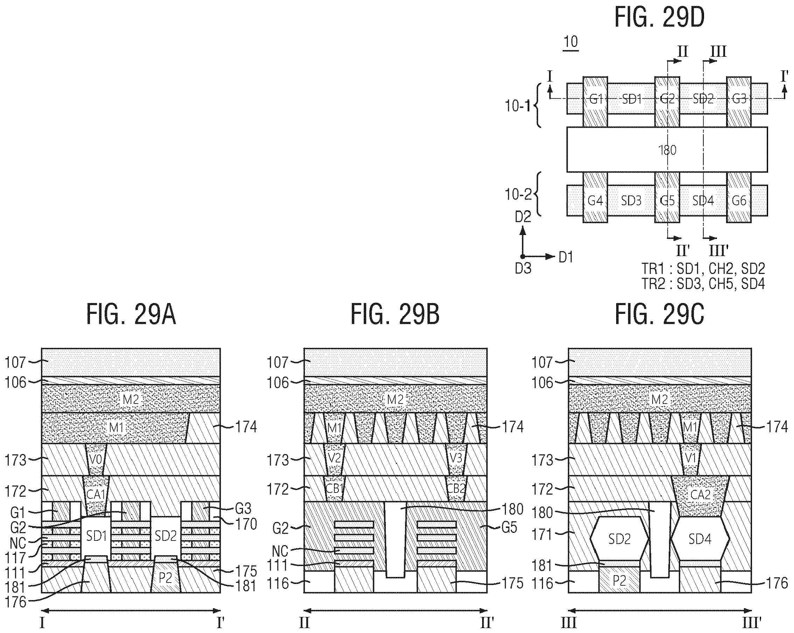

FIGS. 29A-29D illustrate a semiconductor cell after spaces left from the removal of the dummy placeholder structures are filled in with a 6^{th} ILD structure, and a back side of the semiconductor cell is planarized to form the remaining placeholder structures in a 2^{nd} predetermined shape having a positive slope.

Referring to FIGS. 29A and 29C, spaces left from the removal of the 1^{st} and 4^{th} placeholder structures P1 and P4 may be filled in with a 6^{th} ILD structure 176 which is another backside ILD structure, and the back side of the semiconductor cell 10 may be planarized through, for example, a CMP operation such that the 2^{nd} and 3^{rd} placeholder structures P2 and P3 may take a 2^{nd} predetermined shape such as a trapezoid having positive slopes at least one of a cross-section view in the channel-length direction and a cross-section view in the channel-width direction. The planarization operation in this step to obtain the 2^{nd} and 3^{rd} placeholder structures P2 and P3 having the predetermined shape having positive slopes may be performed in order to facilitate deposition of the backside contact plugs in the spaces obtained by removing the 2^{nd} and 3^{rd} placeholder structures P2 and P3 in a later step, as will be described later.

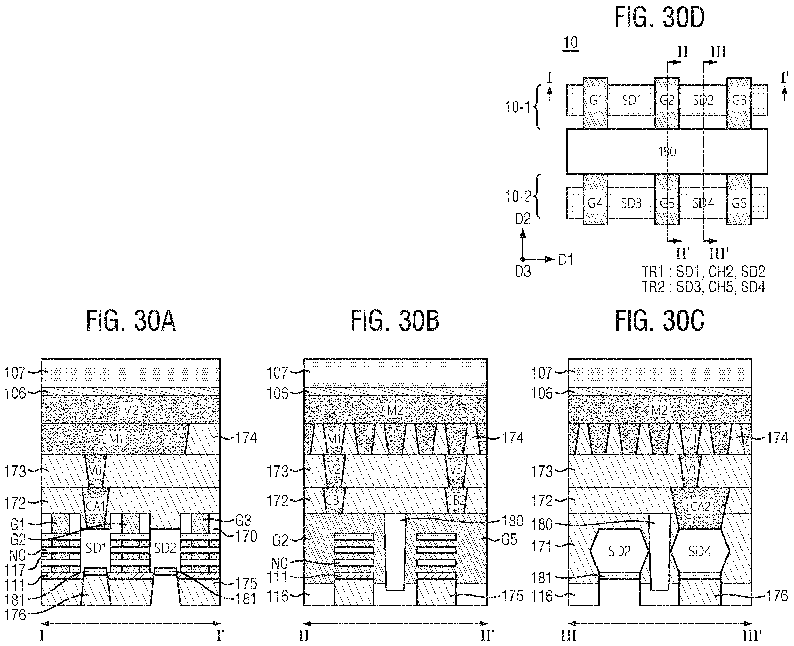

FIGS. 30A-30D illustrate a semiconductor cell after the remaining placeholder structures are removed.

Referring to FIGS. 30A and 30C, the 2^{nd} and 3^{rd} placeholder structures may be extracted through, for example, wet etching against the blocking layers 181 as well as the 5^{th} and 6^{th} ILD structures 175 and 176, and the STI structure 116. According to an embodiment, this wet etching may selectively remove the 2^{nd} and 3^{rd} placeholder structures P2 and P3 formed of silicon germanium (SiGe) without affecting the 2^{nd} and 3^{rd} source/drain regions SD2 and SD3 which are also formed of silicon germanium (SiGe) with the blocking layer 181 formed of silicon or a dielectric material (silicon oxide or silicon nitride) therebelow. In other words, the blocking layers 181 may prevent material loss of the 2^{nd} and 3^{rd} source/drain regions SD2 and SD3 when the 2^{nd} and 3^{rd} placeholder structures are removed in this step.

However, this blocking layer 181 may not have been formed on the 1^{st} to 4^{th} placeholder structures P1-P4 unlike in FIGS. 8A-8D when the 1^{st} to 4^{th} source/drain regions SD1-SD4 are formed of not silicon germanium (SiGe) but silicon (Si) so that the two nanosheet transistors TR1 and TR2 respectively including the 1^{st} to 4^{th} source/drain regions SD1-SD4 are to become n-type field-effect transistors. This is because when the 1^{st} to 4^{th} placeholder structures P1-P4 formed of silicon germanium (SiGe) are wet-etched, loss of silicon (Si) forming the 1^{st} to 4^{th} source/drain regions SD1-SD4 may be avoided or minimized even without the blocking layers 181 due to etch selectivity between the two materials.

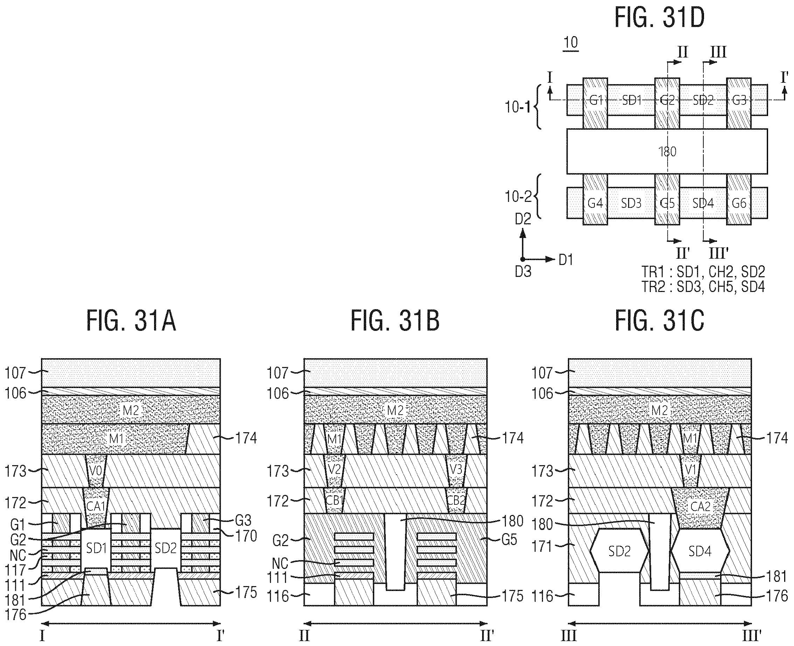

FIGS. 31A-31D illustrate a semiconductor cell after the blocking layers are removed.

Referring to FIGS. 31A-31C, the blocking layers 181 formed below the 2^{nd} and 3^{rd} source/drain regions SD2 and SD3 may be removed through, for example, dry or wet etching that selectively affects the silicon or the dielectric material such as silicon oxide or silicon nitride forming the blocking layer 181 against the material forming the 2^{nd} and 3^{rd} source/drain regions SD2 and SD3, that is, silicon germanium (SiGe). However, unlike in FIGS. 31A-31D, the blocking layers 181 below the 2^{nd} and 3^{rd} source/drain regions SD2 and SD3 may remain without being removed like the blocking layers 181 below the 1^{st} and 4^{th} source/drain regions SD1 and SD4 to simplify the manufacturing process and control a contact resistance between each of the 2^{nd} and 3^{rd} source/drain regions and the backside contact plug to be formed therebelow in a next step, according to an embodiment.

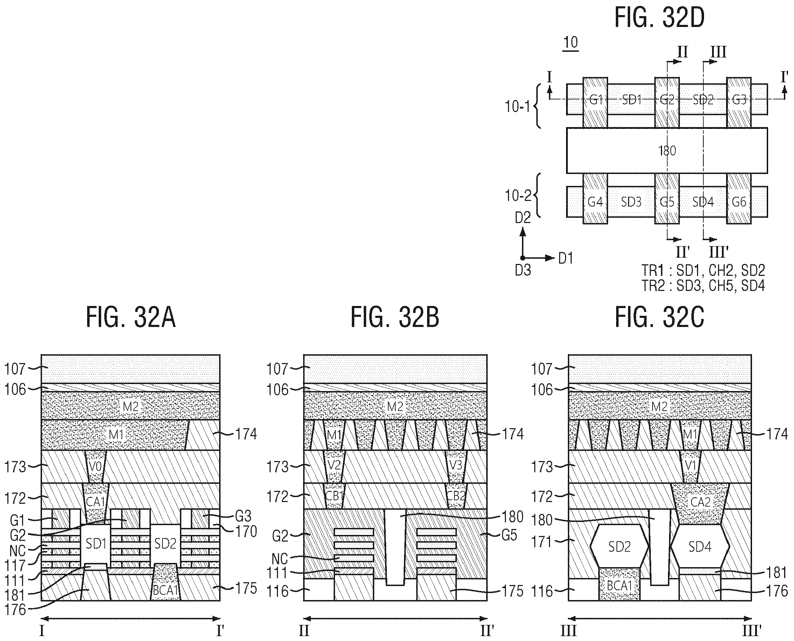

FIGS. 32A-32D illustrate a semiconductor cell after backside contact plugs are formed in spaces left from the removal of the remaining placeholder structures and the blocking layers thereon.

Referring to FIGS. 32A and 32C, 1^{st} and 2^{nd} backside contact plugs BCA1 and BCA2 may be respectively formed in spaces left from the removal of the 2^{nd} and 3^{rd} placeholder structures P2 and P3 and the blocking layers 181 thereon. The formation of the backside contact plugs BCA1 and BCA2 may be performed through, for example, CVD, PVD, PECVD, ALD and their combination thereof, not being limited thereto. Here, since the spaces left from the removal of the 2^{nd} and 3^{rd} placeholder structures P2 and P3 may have the 2^{nd} predetermined shape such as a trapezoid having positive slopes, deposition of the backside contact plugs in these spaces may be fully self-aligned with the predetermined shape when the semiconductor cell 10 is flipped upside down.

The 1^{st} and 2^{nd} backside contact plugs BCA1 and BCA2 may be connected to the bottom surfaces of the 2^{nd} and 3^{rd} source/drain regions SD2 and SD3, respectively. The 2^{nd} backside contact plugs BCA2 connecting the 3^{rd} source/drain region SD3 to placeholder structures P3 is not shown in FIGS. 32A-32C for brevity purposes.

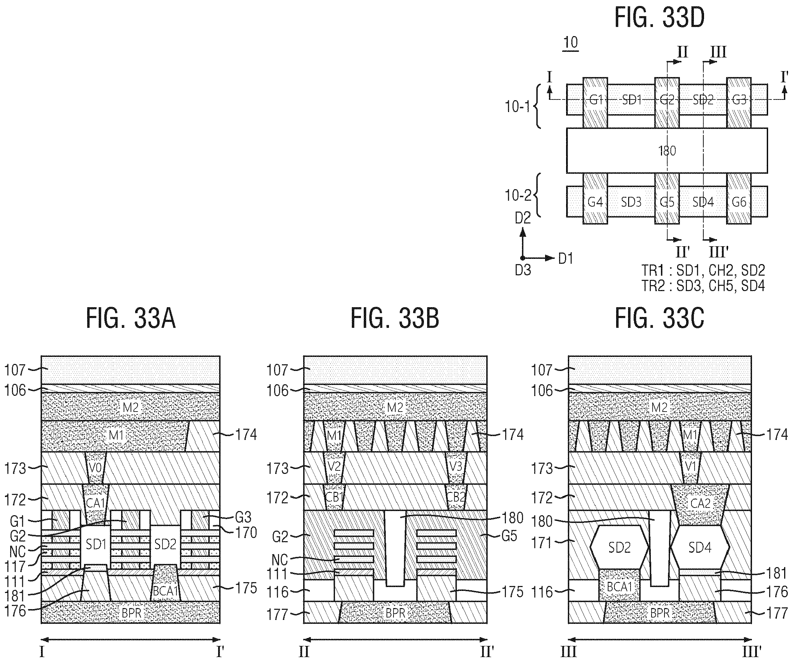

FIGS. 33A-33D illustrate a semiconductor cell after a 7^{th} ILD structure and a backside power rail therein.

Referring to FIGS. 33A-33D, a 7^{th} ILD structure 177 and a backside power rail BPR may be formed on the back side of the semiconductor cell 10 obtained in the previous step to complete the semiconductor chip 10.

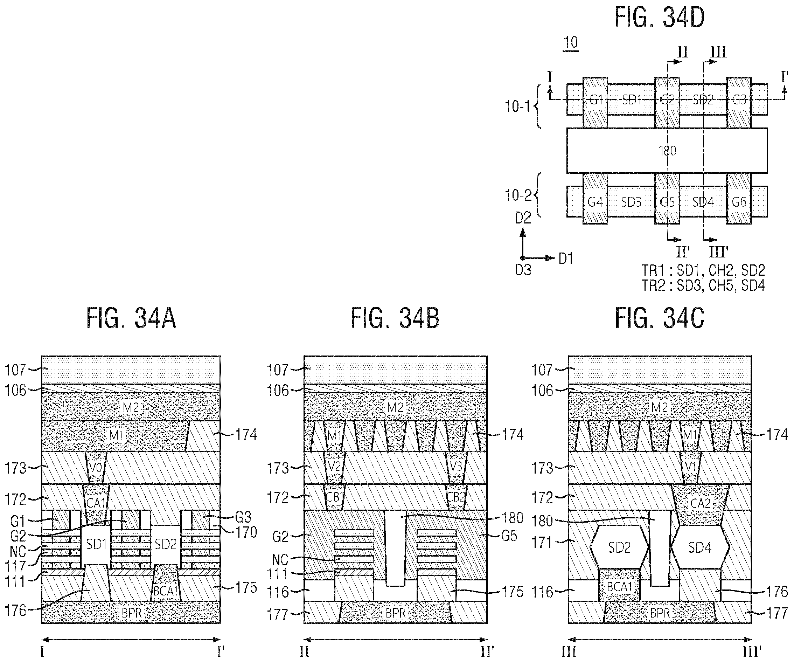

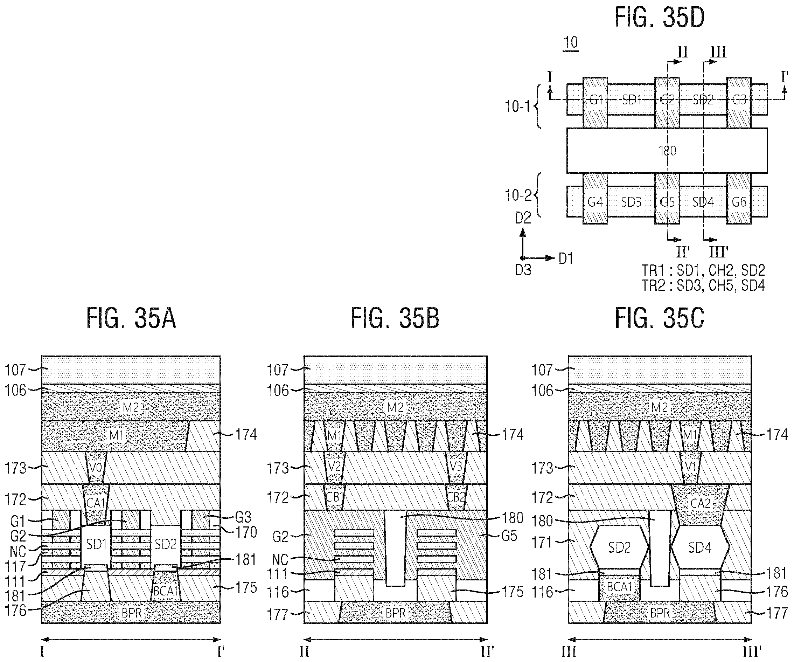

Thus, the 2^{nd} source/drain region SD2 forming the 1^{st} nanosheet transistor TR1 and the 3^{rd} source/drain region SD3 forming the 2^{nd} nanosheet transistor TR2 may be powered through the 1^{st} and 2^{nd} backside contact plugs BCA1 and BCA2, respectively. In the meantime, the semiconductor chip 10 shown in FIGS. 33A-33D may take slightly different structural forms as shown in FIGS. 34A-34D and FIGS. 35A-35D, according to embodiments.

FIGS. 34A-34D illustrate a semiconductor cell in which no blocking layers remain between source/drain regions and the 6^{th} ILD structures after the semiconductor cell is finished up, according to an embodiment.

As described above in reference to FIGS. 28A-28D, the blocking layers 181 on the 1^{st} and 4^{th} placeholder structures P1 and P4 and below the 1^{st} and 4^{th} source/drain regions SD1 and SD4 may also be removed, according to an embodiment. Thus, in this embodiment as shown in FIGS. 34A and 34C, there is no blocking layer 181 remaining below each of the 1^{st} and 4^{th} source/drain region SD1 and SD4 respectively connected to the 1^{st} and 4^{th} MOL contact plugs CA1 and CA4 in addition that no blocking layer 181 remains below each of the 2^{nd} and 3^{rd} source/drain regions SD2 and SD3 respectively connected to the backside contact plugs BCA1 and BCA2. The present embodiment may enable prevention or decrease of unnecessary interference by these blocking layers 181 to other structural elements including the 1^{st} and 4^{th} source/drain regions SD1 and SD4 or the 6^{th} ILD structure formed therebelow.

FIGS. 35A-35D illustrate a semiconductor cell in which blocking layers remain between source/drain regions and the 6^{th} ILD structures and between source/drain regions and backside contact plugs when the semiconductor cell is finished up, according to an embodiment.

As described above in reference to FIGS. 31A-31D, the blocking layers 181 below the 2^{nd} and 3^{rd} source/drain regions SD2 and SD3 may remain without being removed like the blocking layers 181 below the 1^{st} and 4^{th} source/drain regions SD1 and SD4, according to an embodiment. Thus, in this embodiment as shown in FIGS. 35A and 35C, the blocking layers 181 remain below the 2^{nd} and 3^{rd} source/drain region SD2 and SD3 respectively connected to the 1^{st} and 2^{nd} backside contact plugs BCA1 and BCA2 in addition that the blocking layers 181 remains below the 1^{st} and 4^{th} source/drain regions SD1 and SD4 respectively connected to the 1^{st} and 4^{th} MOL contact plugs CA1 and CA4. In the present embodiment, the process of manufacturing the semiconductor cell 10 may be simplified, and a contact resistance between the 2^{nd} and 3^{rd} source/drain regions and the 1^{st} and 2^{nd} backside contact plugs may be controlled by the blocking layers 181.

Thus far, a method of manufacturing a semiconductor cell has been described, in which source/drain regions of two nanosheet transistors are connected to front side contact plugs and backside contact plugs, respectively. In this semiconductor cell, the source/drain region connected to the front side contact plug may have a same or substantially same height or size as the source/drain region connected to the backside contact plug. As an example, the process of manufacturing the semiconductor cell 10 is described, by which the 1^{st} nanosheet transistor TR1 may be formed to include the 1^{st} and 2^{nd} source/drain regions SD1 and SD2 having the same or substantially same height or size even when a front side contact plug, i.e., the 1^{st} MOL contact plug CA1, is formed on the 1^{st} source/drain region SD1 while a backside contact plug, i.e., the 1^{st} backside contact plug BCA1, is formed on the 2^{nd} source/drain region. Further, in the semiconductor cell 10, the 2^{nd} nanosheet transistor TR2 may be formed to include the 3^{rd} and 4^{th} source/drain regions SD3 and SD4 having the same or substantially same height or size even when a front side contact plug, i.e., the 4^{th} MOL contact plug CA2, is formed on the 4^{th} source/drain region SD4 while a backside contact plug, i.e., the 2^{nd} backside contact plug BCA2, is formed on the 3^{rd} source/drain region. Accordingly, each of the 1^{st} nanosheet transistor TR1 and the 2^{nd} nanosheet transistor TR2 may have a stable and consistent device performance. Here, the size of a source/drain region may refer to a height and a width in the channel-width direction.

According to the embodiment, this method of manufacturing the semiconductor cell 10 may be characterized by forming dummy placeholder structures in a substrate, i.e., the 1^{st} and 4^{th} placeholder structures P1 and P4 (dummy placeholder structures) for the 1^{st} and 4^{th} source/drain regions SD1 and SD4 as well as the 2^{nd} and 3^{rd} placeholder structures P2 and P3 for the 2^{nd} and 3^{rd} source/drain regions SD2 and SD3 formed in the substrate 105 so that the epitaxial growth rate can be the same or substantially same between the 1^{st} and 2^{nd} source/drain regions SD1 and SD2 for the 1^{st} nanosheet transistor TR1 and between the 3^{rd} and 4^{th} source/drain regions SD3 and SD4 for the 2^{nd} nanosheet transistor TR2.

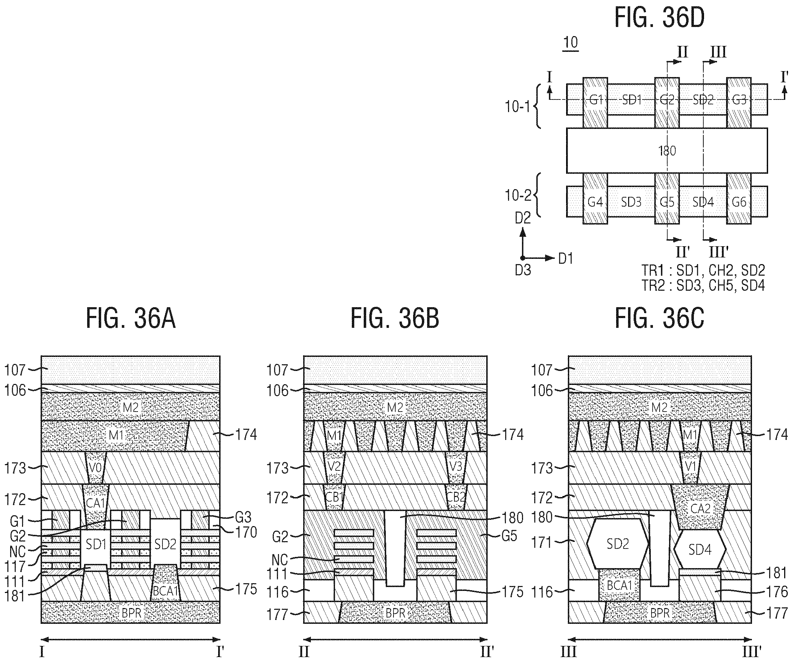

Otherwise, when the 1^{st} and 4^{th} placeholder structures P1 and P4 (dummy placeholder structures) are not formed in the substrate 105 while the 2^{nd} and 3^{rd} placeholder structures P2 and P3 are formed in the substrate 105, the 1^{st} and 4^{th} source/drain regions SD1 and SD4 may be epitaxially grown from only the channel structures while the 2^{nd} and 3^{rd} source/drain regions are epitaxially grown based on not only the channel structures but also the 2^{nd} and 3^{rd} placeholder structures P2 and P3 with the blocking layers 181 thereon, the 2^{nd} and 3^{rd} source/drain regions may have a greater height or size than the 1^{st} and 4^{th} source/drain regions as shown in FIGS. 36A-36D. FIGS. 36A-36D illustrate a semiconductor cell including two field-effect transistors each of which has two source/drain regions having different heights or sizes, according to an embodiment.

Thus, when a nanosheet transistor having differently-sized source/drain regions respectively connected to a front side contact plug and a backside contact plug is required in the semiconductor cell 10 described above, the 1^{st} and 4^{th} placeholder structures P1 and P4 may not be formed in manufacturing the semiconductor cell 10 including the 1^{st} to 4^{th} nanosheet transistors TR1-TR4, according to an embodiment. In this case, however, each of the 1^{st} nanosheet transistor TR1 and the 2^{nd} nanosheet transistor TR2 may have a different device performance because of the differently-sized source/drain regions.

In the meantime, the above embodiments are described for manufacturing a semiconductor cell including two nanosheet transistors. However, the disclosure may not be limited thereto but may also apply to a semiconductor cell including different types of field-effect transistor such as a FinFET.

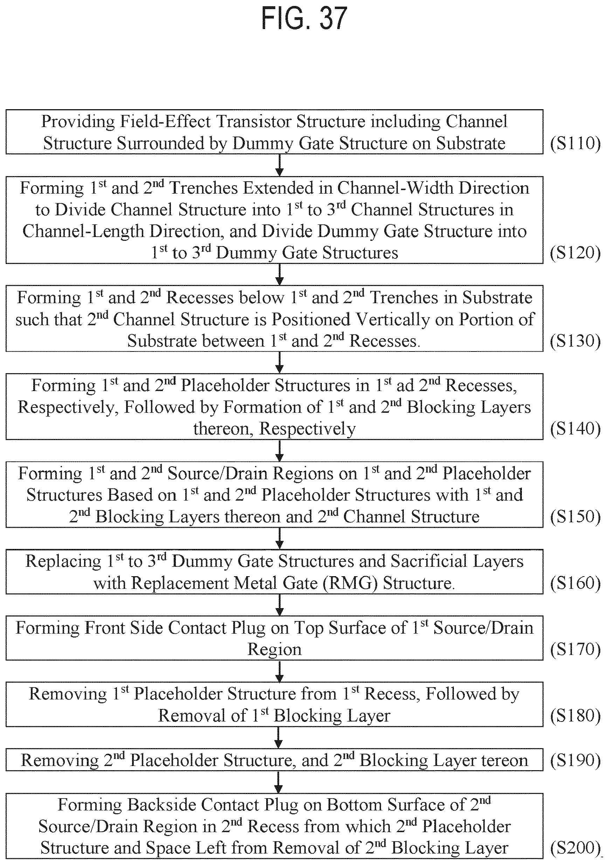

FIG. 37 is a flowchart illustrating a method of manufacturing a semiconductor device including a field-effect transistor of which source/drain regions are connected to a front side contact plug and a backside contact plug, respectively, according to embodiments.

In operation S110, a field-effect transistor structure including a channel structure surrounded by a dummy gate structure may be provided on a substrate.

The channel structure may include a plurality of nanosheet layers for a nanosheet transistor or vertical fin structures for a FinFET. The channel structures may also include sacrificial layers respectively formed below or above the nanosheet layers.

On the substrate may be formed a base diffusion isolation or bottom dielectric isolation (BDI) layer to isolate the substrate at least from the sacrificial layers included in the channel structure. After this operation S110, thee semiconductor cell 10 shown in FIGS. 1A-1D may be provided.

In operation 5120, 1^{st} and 2^{nd} trenches extended in a channel-width direction may be formed to divide the channel structure into 1^{st} to 3^{rd} channel structures in a channel-length direction, and divide the dummy gate structure into 1^{st} to 3^{rd} dummy gate structures.

As the two trenches are formed, the BDI layer formed on the substrate may be exposed through the two trenches, as shown in FIGS. 1A-1D.

In operation S130, 1^{st} and 2^{nd} recesses may be formed below the 1^{st} and 2^{nd} trenches in the substrate such that the 2^{nd} channel structure is positioned vertically on a portion of the substrate between the 1^{st} and 2^{nd} recesses. The 1^{st} and 2^{nd} recesses may be formed in this operation to have a predetermined shape having a positive slope, as shown in FIGS. 6A-6D.

In operation S140, 1^{st} and 2^{nd} placeholder structures may be formed in the 1^{st} and 2^{nd} recesses, respectively, followed by formation of 1^{st} and 2^{nd} blocking layers thereon, respectively, as shown in FIGS. 8A-8D.

In operation S150, 1^{st} and 2^{nd} source/drain regions may be formed on the 1^{st} and 2^{nd} placeholder structures, respectively, for example, by epitaxially growing silicon based on the 1^{st} and 2^{nd} placeholder structures with the 1^{st} and 2^{nd} blocking layers thereon and at least the 2^{nd} channel structure, as shown in FIGS. 10A-10D.

Here, the 1^{st} source/drain region may also be epitaxially grown from the 1^{st} channel structure, and the 2^{nd} source/drain region may also be epitaxially grown from the 3^{rd} channel structure.

In operation S160, the 1^{st} to 3^{rd} dummy gate structures and the sacrificial layers included in the 1^{st} to 3^{rd} channel structures may be replaced by a replacement metal gate (RMG) structure, as shown in FIGS. 13A-13D.

In operations S170, a front side contact plug may be formed on a top surface of the 1^{st} source/drain region, as shown in FIGS. 19A-19D.

The front side contact plug may connect the 1^{st} source/drain region to a BEOL structure such as a metal line connected to a voltage source or another circuit element.

In operation S180, the 1^{st} placeholder structure may be removed from the 1^{st} recess as shown in FIGS. 28A-28D.

According to an embodiment, the 1^{st} blocking layer may also be removed after the 1^{st} placeholder structure is removed.

According to an embodiment, this removal operation and subsequent operations may be performed by flipping the semiconductor device obtained in the previous operation upside down to facilitate various etching and deposition operations.

After the 1^{st} placeholder structure and the 1^{st} blocking layer are used to form the 1^{st} source/drain region, these two structures may not need to remain in the semiconductor device, and thus, may be removed from the semiconductor device.

A space left from the removal of the 1^{st} placeholder structure and the 1^{st} blocking layer may be filled with an ILD structure, as shown in FIGS. 29A-29D.

In operation S190, the 2^{nd} placeholder structure may be removed, and then, the 2^{nd} blocking layer thereon may also be removed, as shown in FIGS. 31A-31D. The 2^{nd} blocking layer may be used to prevent loss of the epitaxially grown 2^{nd} source/drain region when the 2^{nd} placeholder structure is removed.

In operation S200, a backside contact plug formed on a bottom surface of the 2^{nd} source/drain region may be formed in the 2^{nd} recess from which the 2^{nd} placeholder structure and a space left from the removal of the 2^{nd} blocking layer, as shown in FIGS. 34A-34D.

The backside contact plug may connect the 2^{nd} source/drain region to a backside power rail to implement a BSPDN for the semiconductor device.

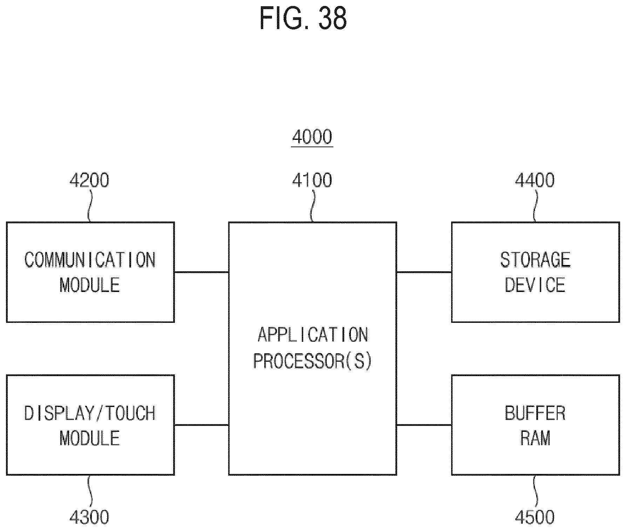

FIG. 38 is a schematic block diagram illustrating an electronic device including a field-effect transistor having both a front side contact plug and a backside contact plug as shown in FIGS. 33A-33D, FIGS. 34A-34D, FIGS. 35A-35D or FIGS. 36A-36D, according to an example embodiment.

Referring to FIG. 38, an electronic device 4000 may include at least one application processor 4100, a communication module 4200, a display/touch module 4300, a storage device 4400, and a buffer random access memory (RAM) 4500. The electronic device 4000 may be a mobile device such as a smartphone or a tablet computer, not being limited thereto, according to embodiments.

The application processor 4100 may control operations of the electronic device 4000. The communication module 4200 is implemented to perform wireless or wire communications with an external device. The display/touch module 4300 is implemented to display data processed by the application processor 4100 and/or to receive data through a touch panel. The storage device 4400 is implemented to store user data. The storage device 4400 may be an embedded multimedia card (eMMC), a solid state drive (SSD), a universal flash storage (UFS) device, etc. The storage device 4400 may perform caching of the mapping data and the user data as described above.

The buffer RAM 4500 may temporarily store data used for processing operations of the electronic device 4000. For example, the buffer RAM 4500 may be volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

Although not shown in FIG. 38, the electronic device 4000 may further include at least one sensor such as an image sensor.

At least one component in the electronic device 4000 may include a field-effect transistor such as the 1^{st} nanosheet transistor TR1 or the 1^{st} nanosheet transistor TR2 shown in FIGS. 33A-33D, FIGS. 34A-34D, FIGS. 35A-35D or FIGS. 36A-36D.

The foregoing is illustrative of example embodiments and is not to be construed as limiting the disclosure. Although some example embodiments have been described above, those skilled in the art will readily appreciate that many modifications are possible in the above embodiments without materially departing from the disclosure.

## Claims

1. A field-effect transistor structure comprising:
a channel structure;
a 1^{st} source/drain region and a 2^{nd} source/drain region connected to each other through the channel structure;
a 1^{st} contact plug, on a top surface of the 1^{st} source/drain region, connected to a 1^{st} voltage source or a circuit element through a back-end-of-line, BEOL, structure; and
a 2^{nd} contact plug, on a bottom surface of the 2^{nd} source/drain region, connected to the 1^{st} voltage source, through a backside power rail, or another circuit element,
wherein the 1^{st} source/drain region and the 2^{nd} source/drain region have a substantially same height.

2. The field-effect transistor structure of claim 1, further comprising a backside interlayer dielectric, ILD, structure connected to a bottom surface of the 1^{st} source/drain region.

3. The field-effect transistor structure of claim 2, further comprising a blocking layer between the backside ILD structure and the 1^{st} source/drain region,
wherein the blocking layer comprises silicon or a dielectric material.

4. The field-effect transistor structure of any one of claims 1 to 3, wherein each of the 1^{st} and 2^{nd} source/drain regions comprises p-type impurities.

5. The field-effect transistor structure of any one of claim 1 to 4, wherein a side surface of the 2^{nd} contact plug has a positive slope such that a width of a top surface of the 2^{nd} contact plug facing the bottom surface of the 2^{nd} source/drain region is smaller than a width of a bottom surface of the 2^{nd} contact plug facing the backside power rail.

6. The field-effect transistor structure of any one of claims 1 to 5, wherein no silicon substrate is formed below the 1^{st} and 2^{nd} source/drain regions.

7. The field-effect transistor structure of any one of claims 1 to 6, further comprising a blocking layer between the 2^{nd} source/drain region and the 2^{nd} contact plug,
wherein the blocking layer comprises silicon or a dielectric material.

8. The field-effect transistor structure of any one of claims 1 to 7, wherein the channel structure comprises a plurality of nanosheet layers.

9. A method of manufacturing a semiconductor device comprising a field-effect transistor, the method comprising:
forming a channel structure on a substrate;
forming 1^{st} and 2^{nd} recesses on the substrate such that the channel structure is positioned vertically on a portion of the substrate between the 1^{st} and 2^{nd} recesses;
forming 1^{st} and 2^{nd} placeholder structures in the 1^{st} and 2^{nd} recesses, respectively;
forming 1^{st} and 2^{nd} source/drain regions on the 1^{st} and 2^{nd} placeholder structures, respectively;
removing the 1^{st} and 2^{nd} placeholder structures from the 1^{st} and 2^{nd} recesses; and
forming a backside contact plug in the 2^{nd} recess from which the 2^{nd} placeholder structure is removed.

10. The method of claim 9, further comprising;
forming a front side contact plug on a top surface of the 1^{st} source/drain region.

11. The method of claim 9 or 10, further comprising:
forming 1^{st} and 2^{nd} blocking layers on the 1^{st} and 2^{nd} placeholder structures, respectively.
wherein each of the 1^{st} and 2^{nd} blocking layers comprises silicon or a dielectric material.
